# EUROPEAN PATENT SPECIFICATION

(11) **EP 4 362 095 B1**
(45) Date of publication and mention of the grant of the patent: **22.04.2026**
(21) Application number: 23206035.0
(22) Date of filing: 26.10.2023
(51) Int. Cl.: H10D 89/60

(54) **DEVICE FOR ELECTROSTATIC DISCHARGE PROTECTION USING SILICON CONTROLLED RECTIFIER**
VORRICHTUNG ZUM SCHUTZ VOR ELEKTROSTATISCHER ENTLADUNG MIT EINEM SILICIUMGESTEUERTEN GLEICHRICHTER
DISPOSITIF DE PROTECTION CONTRE LES DÉCHARGES ÉLECTROSTATIQUES UTILISANT UN REDRESSEUR COMMANDÉ AU SILICIUM

(30) Priority: 28.10.2022 KR 20220141613; 02.01.2023 KR 20230000365
(43) Date of publication of application: 01.05.2024
(73) Proprietor: Samsung Electronics Co., Ltd., Suwon-si, Gyeonggi-do 16677 (KR)
(72) Inventor: DO, Kyoungil, 16677 Suwon-si, Gyeonggi-do (KR); JUNG, Jinwoo, 16677 Suwon-si, Gyeonggi-do (KR); SONG, Jooyoung, 16677 Suwon-si, Gyeonggi-do (KR); LEE, Mijin, 16677 Suwon-si, Gyeonggi-do (KR); JEON, Chanhee, 16677 Suwon-si, Gyeonggi-do (KR)
(74) Representative: Kuhnen & Wacker Patent- und Rechtsanwaltsbüro PartG mbB

(56) References cited:
- US-A- 5 400 202
- US-A1- 2005 212 009
- US-A1- 2012 099 229
- US-A1- 2012 170 160
- US-A1- 2014 015 052
- US-A1- 2019 371 924
- US-B1- 7 859 804

## Description

### BACKGROUND

### 1. Field

The disclosure relates to a device for electrostatic discharge protection, and particularly, to device for electrostatic discharge (ESD) protection using a silicon controlled rectifier.

### 2. Description of Related Art

US 2019/371924 A1 discloses a thyristor tile that includes first and second PNP tiles and first and second NPN tiles. Each PNP tile is adjacent to both NPN tiles, and each NPN tile is adjacent to both PNP tiles. A thyristor includes a plurality of PNP tiles and a plurality of NPN tiles. The PNP and NPN tiles are arranged in an alternating configuration in both rows and columns. The PNP tiles are oriented perpendicular to the NPN tiles. Interconnect layers have a geometry that enables even distribution of signals to the PNP and NPN tiles.

US 7859804 B1 discloses a sense circuit to detect an ESD event and to turn on an SCR to discharge the ESD event. The circuit comprises a resistor in the signal path to/from an I/O buffer, a sense circuit in parallel with the resistor, an SCR connected between ground and a node between the resistor and the I/O pad, and an I/O buffer connected between ground and the other end of the resistor. When the sense circuit detects a significant voltage drop across the resistor, it injects current into the SCR, thereby turning on the SCR and discharging the ESD event.

US 2005/212009 A1 discloses a semiconductor device that includes a thyristor, trigger circuit and surge detection/leakage reduction circuit. The anode of the thyristor is connected to a first terminal and the cathode thereof is connected to a second terminal. The trigger circuit is configured to fire the thyristor when surge voltage is applied to the first terminal. The surge detection/leakage reduction circuit is provided between the gate of the thyristor and the second terminal and configured to interrupt current flowing from the trigger circuit to the second terminal in the normal operation mode and set trigger voltage which is used to fire the thyristor in cooperation with the trigger circuit at the surge voltage application time.

US 2014/015052 A1 discloses an integrated circuit that includes an UTBOX insulating layer under and plumb with first and second electronic components, and corresponding ground planes and oppositely-doped wells made plumb with them. The wells contact with corresponding ground planes. A pair of oppositely doped bias electrodes, suitable for connecting corresponding bias voltages, contacts respective wells and ground planes. A third electrode contacts the first well. A first trench isolates one bias electrode from the third electrode and extends through the layer and into the first well. A second trench isolates the first bias electrode from one component. This trench has an extent that falls short of reaching an interface between the first ground plane and the first well.

US 2012/170160 A1 discloses an ESD protection circuit that is electrically connected between a first power rail and a second power rail, and includes an ESD protection device, a switching device electrically connected between the ESD protection device and a first power rail, and a low-pass filter electrically connected between the first power rail and the first switching device. The ESD protection device includes a BJT and a first resistor electrically connected between a base of the BJT and a first power rail. When no ESD event occurs, a potential of the base is larger than or equal to a potential of an emitter of the BJT. When the ESD event occurs, the potential of the base is smaller than the potential of the emitter.

US 5400202 A discloses a circuit for protecting integrated circuits from electrostatic discharge by using SCR latchup to divert the ESD current pulse away from sensitive circuit structures. The SCR structure of the invention includes a trigger circuit having an NMOS triggering transistor for activating the SCR when an ESD event occurs on an input/output pad of the integrated circuit being protected. The ESD event on the input/output pad of the integrated circuit is detected by a circuit which applies a trigger voltage to the NMOS triggering transistor to initiate latchup of the SCR independent of junction breakdown of the NMOS triggering transistor. The trigger voltage is generated by an inverter trigger or a capacitor trigger powered by the ESD event so as to trigger SCR latchup so long as the integrated circuit is not powered up (VDD is low). The SCR of the invention may also have a floating well whereby the well resistor Rw of the SCR is replaced by a CMOS device which inhibits forward biasing of the pnp base of the SCR when VDD is high but allows small currents to forward bias the pnp base when VDD is low. The NMOS trigger FET of the invention also may be isolated from the substrate containing the SCR so as to further decrease the effects of junction breakdown conditions on the latchup of the SCR.

US 2012/099229 A1 discloses a semiconductor device that has a first device region disposed on a second device region within an ESD device region disposed within a semiconductor body. Also included is a third device region disposed on the second device region, a fourth device region adjacent to the second device region, a fifth device region disposed within the fourth device region, and a sixth device region adjacent to the fourth device region. The first and fourth regions have a first semiconductor type, and the second, third, fifth and sixth regions have a second conductivity type opposite the first conductivity type. An interface between the fourth device region and the sixth device region forms a diode junction. The first, second, fourth and fifth device regions form a silicon controlled rectifier.

ESD may cause an integrated circuit to malfunction, or even damage the integrated circuit. Accordingly, an integrated circuit may include a component for electrostatic discharge protection, which may protect an internal circuit from electrostatic discharge generated from the outside of the integrated circuit. Due to the development of the semiconductor process, the size of elements included in the integrated circuit may be decreased, the operating voltage of the elements included in the integrated circuit may be decreased for reducing power consumption, and the frequency of signals input to and output from the integrated circuit may be increased for high performance. Accordingly, there is a need for the component for electrostatic discharge protection to have improved performance.

### SUMMARY

The invention is set out in the appended claims.

Provided is a device using a silicon controlled rectifier to improve performance in providing electrostatic discharge protection.

Additional aspects will be set forth in part in the description which follows and, in part, will be apparent from the description, or may be learned by practice of the presented embodiments.

In accordance with an aspect of the disclosure, a device includes a silicon controlled rectifier; at least one first transistor connected between an anode of the silicon controlled rectifier and a gate of the silicon controlled rectifier; and a second transistor, wherein a source of the second transistor is connected to one from among the anode and a cathode of the silicon controlled rectifier, and wherein a drain of the second transistor is connected to a body of the at least one first transistor.

In accordance with an aspect of the disclosure, a device includes a silicon controlled rectifier including a PNP bipolar transistor and a NPN bipolar transistor, wherein a base of the NPN bipolar transistor is connected to a collector of the PNP bipolar transistor, and wherein a collector of the NPN bipolar transistor is connected to a base of the PNP bipolar transistor; a first resistor connected between a gate of the silicon controlled rectifier and a cathode of the silicon controlled rectifier; at least one first transistor connected between the base of the PNP bipolar transistor and the cathode; and a second transistor, wherein a source of the second transistor is connected to one from among the cathode and an anode of the silicon controlled rectifier, and wherein a drain of the second transistor is connected to a body of the at least one first transistor.

In accordance with an aspect of the disclosure, a device includes a silicon controlled rectifier including a PNP bipolar transistor and a NPN bipolar transistor, wherein a base of the NPN bipolar transistor is connected to a collector of the PNP bipolar transistor, and wherein a collector of the NPN bipolar transistor is connected to a base of the PNP bipolar transistor; a first transistor connected to the base of the PNP bipolar transistor or the base of the NPN bipolar transistor; and a second transistor, wherein a drain of the second transistor is connected to a body of the first transistor, wherein the first transistor is surrounded by a first p+ region on a first p-well, and wherein the drain of the second transistor is connected to the first p+ region.

### BRIEF DESCRIPTION OF DRAWINGS

The above and other aspects, features, and advantages of certain embodiments of the present disclosure will be more clearly understood from the following detailed description taken in conjunction with the accompanying drawings, in which:
FIG. 1 is a block diagram of a device according to an embodiment;
FIG. 2 is a plan view of a silicon controlled rectifier according to an embodiment;
FIG. 3 is a graph showing characteristics of a silicon controlled rectifier according to an embodiment;
FIGS. 4A and 4B are circuit diagrams showing examples of devices according to embodiments;
FIG. 5 is a graph showing characteristics of a device according to an embodiment;
FIGS. 6A and 6B are diagrams showing examples of layouts of devices according to embodiments;
FIGS. 7A and 7B are circuit diagrams showing examples of devices according to embodiments;
FIGS. 8A and 8B are diagrams showing examples of layouts of devices according to embodiments;
FIGS. 9A and 9B are circuit diagrams showing examples of devices according to embodiments;
FIGS. 10A and 10B are diagrams showing examples of layouts of devices according to embodiments;
FIGS. 11A and 11B are circuit diagrams showing examples of devices according to embodiments;
FIGS. 12A and 12B are diagrams showing examples of layouts of devices according to embodiments;
FIG. 13A is a circuit diagram of a device according to an example embodiment, and FIG. 13B is a graph showing characteristics of the device according to an embodiment;
FIG. 14A is a circuit diagram of a device according to an example embodiment, and FIG. 14B is a graph showing characteristics of the device according to an embodiment;
FIG. 15A is a circuit diagram of a device according to an example embodiment, and FIG. 15B is a graph showing characteristics of the device according to an embodiment;
FIG. 16A is a circuit diagram of a device according to an example embodiment, and FIG. 16B is a graph showing characteristics of the device according to an embodiment;
FIGS. 17A and 17B are circuit diagrams showing examples of devices according to embodiments;
FIG. 18A is a circuit diagram of a device according to an example embodiment, and FIG. 18B is a graph showing characteristics of the device according to an embodiment; and
FIG. 19A is a circuit diagram of a device according to an example embodiment, and FIG. 19B is a graph showing characteristics of the device according to an embodiment.

### DETAILED DESCRIPTION

Hereinafter, embodiments of the present disclosure will be described as follows with reference to the accompanying drawings.

As is traditional in the field, the embodiments are described, and illustrated in the drawings, in terms of functional blocks, units and/or modules. Those skilled in the art will appreciate that these blocks, units and/or modules are physically implemented by electronic (or optical) circuits such as logic circuits, discrete components, microprocessors, hard-wired circuits, memory elements, wiring connections, and the like, which may be formed using semiconductor-based fabrication techniques or other manufacturing technologies. In the case of the blocks, units and/or modules being implemented by microprocessors or similar, they may be programmed using software (e.g., microcode) to perform various functions discussed herein and may optionally be driven by firmware and/or software. Alternatively, each block, unit and/or module may be implemented by dedicated hardware, or as a combination of dedicated hardware to perform some functions and a processor (e.g., one or more programmed microprocessors and associated circuitry) to perform other functions. Also, each block, unit and/or module of the embodiments may be physically separated into two or more interacting and discrete blocks, units and/or modules without departing from the present scope. Further, the blocks, units and/or modules of the embodiments may be physically combined into more complex blocks, units and/or modules without departing from the present scope.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c

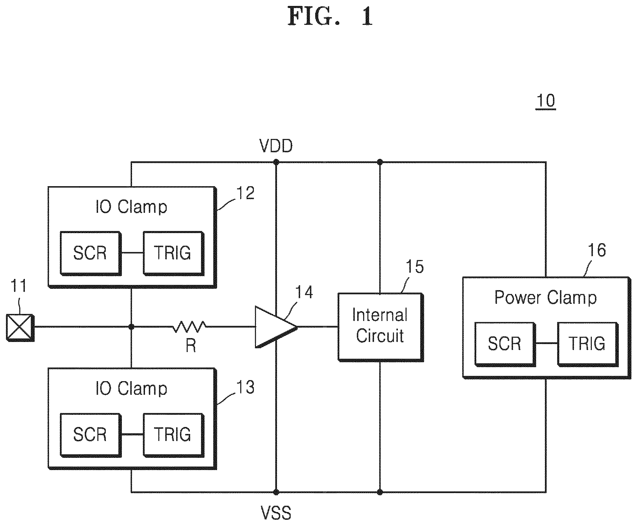

FIG. 1 is a block diagram of a device according to an example embodiment. In some embodiments, a device (e.g., a device for electrostatic discharge protection) 10 may include an integrated circuit manufactured by a semiconductor process. For example, the device 10 may be a chip or a die, or may be a semiconductor package including at least one chip or die. As shown in FIG. 1, the device 10 may include an input/output (IO) pad 11, a first IO clamp 12, a second IO clamp 13, a resistor R, a buffer 14, an internal circuit 15, and a power clamp 16.

The IO pad 11 may be exposed to the outside of the device 10, and a signal received through the IO pad 11 may be provided to the internal circuit 15 through the resistor R and the buffer 14. As shown in FIG. 1, the IO pad 11 may be connected to the first IO clamp 12 and the second IO clamp 13. Herein, when two or more components are referred to as connected, this may mean that the two or more components are electrically connected. For example, when two components are referred to as being connected by a resistor, the two components may be electrically connected to each other.

When electrostatic discharge occurs in the IO pad 11, the first IO clamp 12 may form a low-impedance discharge path between the IO pad 11 and a positive supply voltage VDD node. Similarly, when electrostatic discharge occurs in the IO pad 11, the second IO clamp 13 may form a low-impedance discharge path between the IO pad 11 and a negative supply voltage VSS node. In addition, when electrostatic discharge occurs between the positive supply voltage VDD node and the negative supply voltage VSS node, the power clamp 16 may form a low-impedance discharge path between the positive supply voltage VDD node and the negative supply voltage node VSS. Accordingly, the internal circuit 15 may be protected from the electrostatic discharge by the first IO clamp 12, the second IO clamp 13, and the power clamp 16.

Due to the development of the semiconductor process, the size of the elements included in the internal circuit 15 may be reduced, and the junction depth and the thickness of the gate oxide may be reduced. In addition, for low power consumption and high operating speed, a voltage difference in an operating voltage of the internal circuit 15, for example, a voltage difference between the positive supply voltage VDD and negative supply voltage VSS, may be decreased, and the frequency of a signal being input and output through the IO pad 11 may be increased. Therefore, there may be a need for the first IO clamp 12, the second IO clamp 13, and the power clamp 16 to meet higher operating parameters, for example, high current driving capacity, low operation start voltage, low leakage current, low capacitance, and the like.

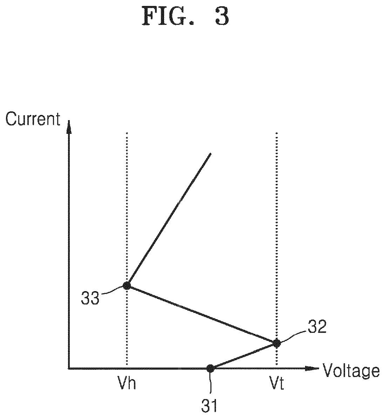

As shown in FIG. 1, the first IO clamp 12, the second IO clamp 13, and the power clamp 16 may each include a silicon controlled rectifier SCR and a trigger circuit TRIG. The silicon controlled rectifier SCR may have a high current density based on double injection, and may provide high electrostatic discharge performance per unit area, reduced area, and reduced capacitance. However, as described below with reference to FIG. 3, as a snapback element, the silicon controlled rectifier SCR may have a high operation start voltage due to a high breakdown voltage between wells, and when only the silicon controlled rectifier SCR is used for electrostatic discharge prevention, the internal circuit 15 having low voltage may be damaged.

As described below, the trigger circuit TRIG may generate a trigger current when the electrostatic discharge occurs, and the trigger current may allow the silicon controlled rectifier SCR to form a low-impedance path. In addition, the trigger circuit TRIG may generate a trigger current at a low voltage, and may also have a low leakage current. Accordingly, the elements of the internal circuit 15 having a low operating voltage may be safely protected from the electrostatic discharge, the malfunction of the device 10 may be prevented, and the power consumption may be reduced.

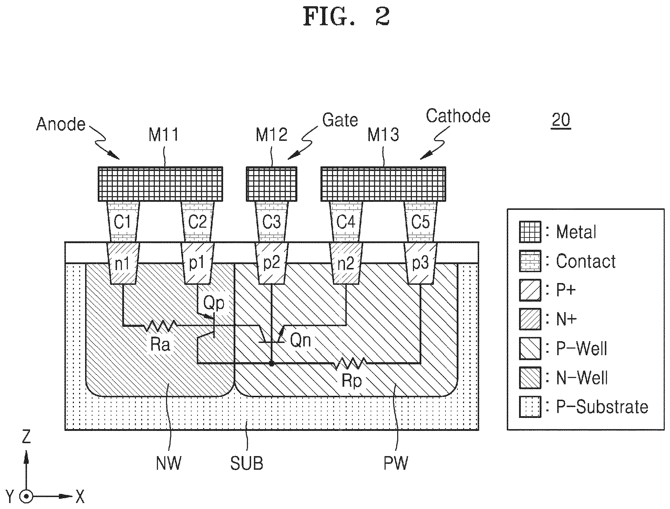

FIG. 2 is a cross-sectional view of a silicon controlled rectifier 20 according to an example embodiment, and FIG. 3 is a graph showing characteristics of the silicon controlled rectifier 20 according to an exemplary embodiment. For example, the cross-sectional view of FIG. 2 shows both a cross-section of the silicon controlled rectifier 20 cut with a plane including an X-axis and a Z-axis and an equivalent circuit of the silicon controlled rectifier 20, and the graph of FIG. 3 shows a snapback curve of the silicon controlled rectifier 20.

Herein, the X-axis direction may be referred to as a first horizontal direction, the Y-axis direction may be referred to as a second horizontal direction, and the Z-axis direction may be referred to as a vertical direction. A plane including an X axis and a Y axis may be referred to as a horizontal plane, a first component relatively disposed in a +Z direction with respect to a second component may be referred to as being above the second component, and a first component relatively disposed in a -Z direction with respect to a second component may be referred to as being under or below the second component. In addition, the area of a component may refer to a size occupied by the component on a plane parallel to the horizontal plane, and the width of a component may refer to a length in a direction perpendicular to a direction in which the component extends. A surface exposed in the +Z direction may be referred to as a top surface, a surface exposed in the -Z direction may be referred to as a bottom surface, and a surface exposed in ±X or ±Y directions may be referred to as a side surface. A pattern including conductive materials may be referred to as a conductive pattern, and may also be referred to as a pattern.

Referring to FIG. 2, the silicon controlled rectifier 20 may include a PNP bipolar transistor Qp and an NPN bipolar transistor Qn, and bases and collectors of the PNP bipolar transistor Qp and the NPN bipolar transistor Qn may be cross-coupled. An emitter of the PNP bipolar transistor Qp may be referred to as an anode of the silicon controlled rectifier 20, the collector of the PNP bipolar transistor Qp and the base of the NPN bipolar transistor Qn, both connected to each other, may be referred to as a gate of the silicon controlled rectifier 20, and an emitter of the NPN bipolar transistor Qn may be referred to as a cathode of the silicon controlled rectifier 20.

The silicon controlled rectifier 20 may include a resistor Ra connected between the anode and the base of the PNP bipolar transistor Qp (or the collector of the NPN bipolar transistor Qn). In addition, the silicon controlled rectifier 20 may include a resistor Rp connected between the cathode and the base of the NPN bipolar transistor Qn (or the collector of the PNP bipolar transistor Qp). As described below, in some embodiments the resistor Ra and/or the resistor Rp may be omitted in the silicon controlled rectifier 20.

As shown in FIG. 2, the silicon controlled rectifier 20 may consist of wells and doping regions disposed in the wells. For example, an n-well NW and a p-well PW may be disposed in a p-type substrate (e.g., a P-substrate) SUB. In embodiments, an n-well may refer to an n-type well, and a p-well may refer to a p-type well. A first n+ region n1 and a first p+ region p1 may be disposed in the n-well NW. A second p+ region p2, a second n+ region n2, and a third p+ region p3 may be disposed in the p-well PW. Herein, an n+ region may have a concentration of an n-type dopant, the concentration being higher than that of an n-well, and a p+ region may have a concentration of a p-type dopant, the concentration being higher than that of a p-well. In addition, a deep n-well may have a concentration of the n-type dopant, in which the concentration that is similar to that of the n-well NW, or lower than those of the n-well NW and the n+ region. A first contact C1 may be disposed on the first n+ region n1, and a second contact C2 may be disposed on the first p+ region p1. The first contact C1 and the second contact C2 may be connected to each other through a first pattern M11. A third contact C3 may be disposed on the second p+ region p2, and the third contact C3 may be connected to a second pattern M12. A fourth contact C4 may be disposed on the second n+ region n2, and a fifth contact C5 may be disposed on the third p+ region p3. The fourth contact C4 and the fifth contact C5 may be connected to each other through a third pattern M13. Accordingly, the PNP bipolar transistor Qp may include the first p+ region p1 (which may correspond to the emitter), the n-well NW (which may correspond to the base), and the p-well PW (which may correspond to the collector). Further, the NPN bipolar transistor Qn may include the second n+ region n2 (which may correspond to the emitter), the p-well PW (which may correspond to the base), and the n-well NW (which may correspond to the collector). In an example, the resistors Ra and Rp may include well resistors (e.g., resistors included in the n-well NW or resistors included in the p-well PW). For example, the resistor Ra may include a resistor included in the n-well NW, and the resistor Rp may include a resistor included in the p-well PW. In some embodiments, the first n+ region n1 and/or the third p+ region p3 may be omitted, and accordingly, the resistor Ra and/or the resistor Rp may be omitted. In some embodiments, a via may be disposed between a contact and a pattern.

Referring to FIG. 3, the silicon controlled rectifier 20 may have a characteristic corresponding to the snapback curve. For example, as the voltage between the anode and the cathode increases, breakdown may occur between the n-well NW and the p-well PW at the first point 31. At a second point 32, the PNP bipolar transistor Qp and the NPN bipolar transistor Qn may each be turned-on based on a voltage that reached a trigger voltage Vt, and accordingly, the voltage may be decreased and the current may be increased. At a third point 33, the voltage may reach a bipolar hold voltage Vh, and an electrostatic discharge current may flow in a latch mode.

The trigger voltage Vt may, for example, reach 18 V to 20 V due to a high breakdown voltage (e.g., a voltage of the first point 31) between the n-well NW and the p-well PW, and may not be suitable for protecting elements of the internal circuits with low operating voltages such as 3 V and 1.5 V. In addition, the bipolar hold voltage Vh may depend on forward voltage drop, and if the bipolar hold voltage Vh is less than the sum of the operating voltage and margin of the internal circuit, the PNP bipolar transistor Qp and the NPN bipolar transistor Qn may not be turned-off after the electrostatic discharge occurs, and distortion of signals and deterioration and/or damage of the device 10 may be caused. Hereinafter, as described below, the trigger circuit TRIG may lower the trigger voltage Vt while increasing the bipolar hold voltage Vh in the silicon controlled rectifier 20.

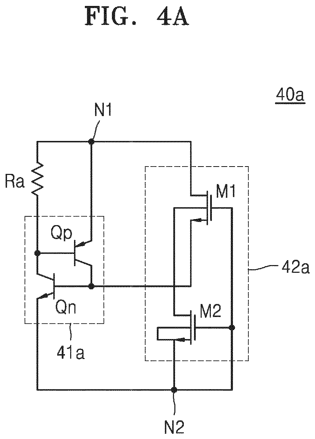

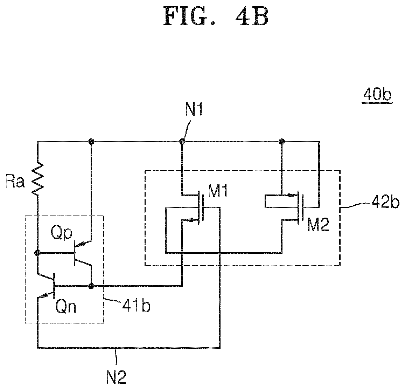

FIGS. 4A and 4B are circuit diagrams showing examples of devices according to exemplary embodiments. For example, the circuit diagrams of FIGS. 4A and 4B respectively show devices 40a and 40b which may provide protection from the electrostatic discharge by forming a current path between a first node N1 and a second node N2 when the electrostatic discharge occurs in the first node N1 or the second node N2. Hereinafter, redundant or duplicative descriptions of aspects that are substantially the same as each other with respect to FIGS. 4A and 4B may be omitted.

Referring to FIG. 4A, the device 40a may include a silicon controlled rectifier 41a, a trigger circuit 42a, and a resistor Ra. In some embodiments, the resistor Ra may include a well resistor, as described with reference to FIG. 2. The silicon controlled rectifier 41a may include a PNP bipolar transistor Qp and a NPN bipolar transistor Qn, may include an anode connected to the first node N1, and may include a cathode connected to the second node N2. The trigger circuit 42a may include a first transistor M1 and a second transistor M2, which may be n-channel field effect transistors (NFETs). The first transistor M1 may include a drain connected to the first node N1, which may be the anode of the silicon controlled rectifier 41a, a source connected to the gate of the silicon controlled rectifier 41a, and a gate connected to the second node N2, which may be the cathode of the silicon controlled rectifier 41a. The second transistor M2 may include a drain connected to a body of the first transistor M1, and a source and a gate which are connected to the cathode of the silicon controlled rectifier 41a.

The second transistor M2 connected to the body of the first transistor M1 may limit a body current of the first transistor M1, and accordingly, may lower the voltage used to generate the trigger current due to the first transistor M1, and may block leakage current through a substrate by a drain-body reverse bond. For example, when electrostatic discharge occurs between the first node N1 and the second node N2, the first transistor M1 connected to the parasitic diode of the silicon controlled rectifier 41a may be operated first. A hole current formed through a p-type body of the first transistor M1 may flow into the source of the first transistor M1 due to the reverse bond (e.g., high resistance) of the second transistor M2, and thus, a low trigger voltage Vt may be achieved. The current generated by the first transistor M1 may be provided to the base of the NPN bipolar transistor Qn through the source of the first transistor M1, and as a result, a current path (or discharge path) having low impedance may be formed from the first node N1 through the PNP bipolar transistor Qp and the NPN bipolar transistor Qn to the second node N2. In addition, a well bond path, which may refer to the leakage current path of the silicon controlled rectifier 41a, may be opened, and a current from the drain to the body may be blocked by a reverse operation of the second transistor M2.

Referring to FIG. 4B, the device 40b may include a silicon controlled rectifier 41b, a trigger circuit 42b, and the resistor Ra. Compared to the device 40a of FIG. 4A, the second transistor M2 may be a p-channel field effect transistor (PFET) in the device 40b of FIG. 4B. The second transistor M2 may include a drain connected to a body of the first transistor M1, and a source and a gate which are connected to the anode of the silicon controlled rectifier 41b. As described with reference to FIG. 4A, the second transistor M2 may limit the body current of the first transistor M1, and accordingly, the trigger voltage Vt may be lowered and the leakage current through the substrate may be blocked by the drain-body reverse bond.

Herein, a field effect transistor (FET) may refer to a type of transistor that uses an electric field to control a current flow. For example, the FET may include a planar FET, a FinFET, a gate-all around FET (GAAFET), a multi-bridge channel FET (MBCFET), a vertical FET (VFET), a ForkFET, a complementary FET (CFET), a negative capacitance FET (NCFET), a carbon nanotube FET (CNTFET), and the like.

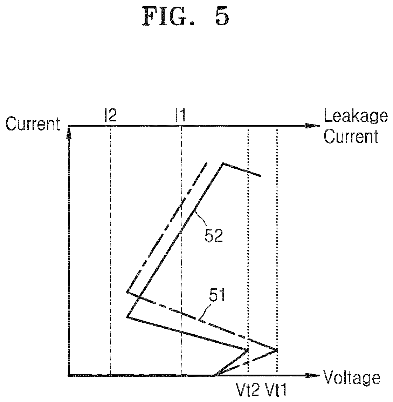

FIG. 5 is a graph showing characteristics of a device according to an example embodiment. For example, the graph of FIG. 5 shows a first snapback curve 51 corresponding to the silicon controlled rectifier 20 of FIG. 2, and a second snapback curve 52 corresponding to the device 40a of FIG. 4A. In addition, the graph of FIG. 5 illustrates a first leakage current I1 of the silicon controlled rectifier 20 of FIG. 2 and a second leakage current I2 of the device 40a of FIG. 4A.

Referring to FIG. 5, the second snapback curve 52 may have a second trigger voltage Vt2 that is less than a first trigger voltage Vt1 of the first snapback curve 51. In addition, the device 40a of FIG. 4A may have the second leakage current I2 that is less than the first leakage current I1 of the silicon controlled rectifier 20 of FIG. 2.

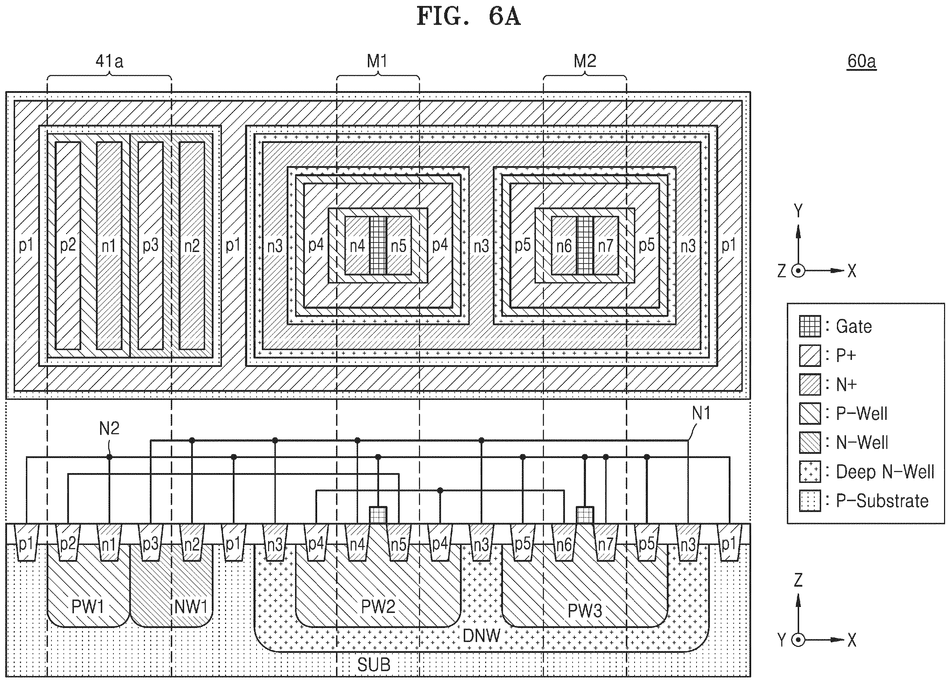

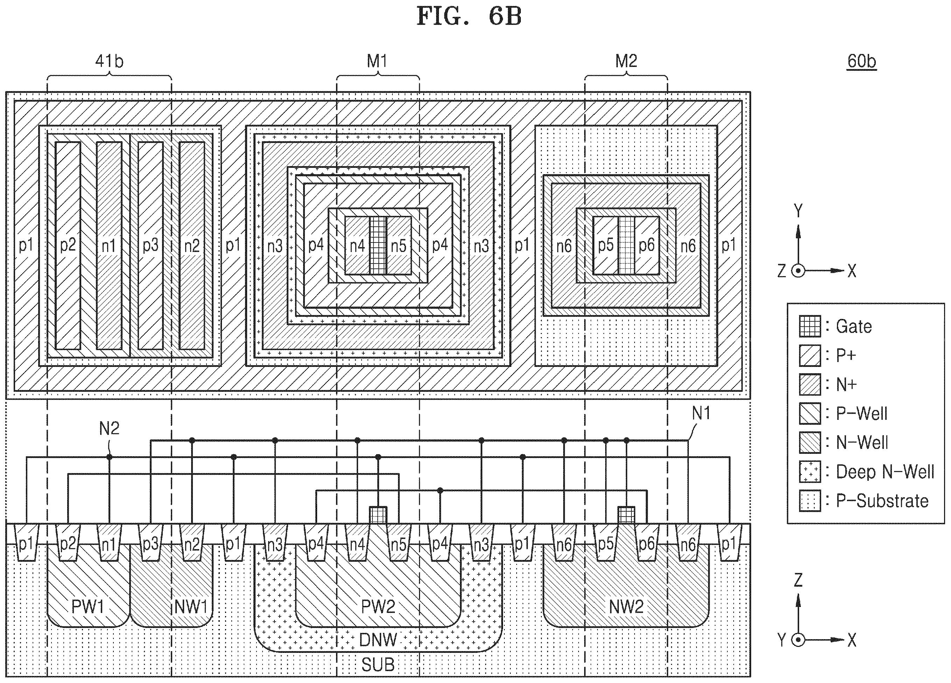

FIGS. 6A and 6B are diagrams showing examples of layouts of devices according to exemplary embodiments. For example, FIG. 6A shows a plan view and a cross-sectional view of a layout 60a corresponding to the device 40a of FIG. 4A, and FIG. 6B shows a plan view and a cross-sectional view of a layout 60b corresponding to the device 40b of FIG. 4B. For convenience of illustration in FIGS. 6A and 6B, contacts and patterns for connecting the p+ regions, the n+ regions, and the gates with one another may be omitted. The devices 40a and 40b of FIGS. 4A and 4B are not respectively limited to the layouts 60a and 60b of FIGS. 6A and 6B, and in embodiments, the devices 40a and 40b of FIGS. 4A and 4B may have different layouts. Hereinafter, FIG. 6A will be described with reference to FIG. 4A, and FIG. 6B will be described with reference to FIG. 4B.

Referring to FIG. 6A, a first p-well PW1, a first n-well NW1, and a deep n-well DNW may be disposed in the substrate SUB. In addition, a second p-well PW2 and a third p-well PW3 may be disposed in the deep n-well DNW. The first p+ region p1 may surround each of the silicon controlled rectifier 41a and the deep n-well DNW on the substrate SUB, and may be connected to the second node N2, which may be the cathode of the silicon controlled rectifier 41a. The second p+ region p2, the first n+ region n1, the third p+ region p3, the first p-well PW1 and the first n-well NW1 may be included in the silicon controlled rectifier 41a. The second p+ region p2 may be connected to a fifth n+ region n5, which may be the source of the first transistor M1. The second n+ region n2 may correspond to a resistor of the first n-well NW1, which may be an end of the resistor Ra, and may be connected to the first node N1, which may be the anode of the silicon controlled rectifier 41a.

The third n+ region n3 may surround each of the second p-well PW2 and the third p-well PW3 on the deep n-well DNW, and may be connected to the first node N1. A fourth p+ region p4 may surround the first transistor M1 on the second p-well PW2, and may be connected to a sixth n+ region n6, which may be the drain of the second transistor M2. A fourth n+ region n4, the fifth n+ region n5, and the corresponding gate may be included in the first transistor M1. A fifth p+ region p5 may surround the second transistor M2 on the third p-well PW3 and may be connected to the second node N2. The sixth n+ region n6, a seventh n+ region n7, and the corresponding gate may be included in the second transistor M2.

Referring to FIG. 6B, the first p-well PW1, the first n-well NW1, the deep n-well DNW, and a second n-well NW2 may be disposed in the substrate SUB. In addition, a second p-well PW2 may be disposed in the deep n-well DNW. The first p+ region p1 may surround each of the silicon controlled rectifier 41b, the deep n-well DNW, and the second n-well NW2 on the substrate SUB, and may be connected to the second node N2, which may be the cathode of the silicon controlled rectifier 41b. The second p+ region p2, the first n+ region n1, the third p+ region p3, the first p-well PW1 and the first n-well NW1 may be included in the silicon controlled rectifier 41b. The second p+ region p2 may be connected to the fifth n+ region n5, which may be the source of the first transistor M1. The second n+ region n2 may correspond to a resistor of the first n-well NW1, which may be the end of the resistor Ra, and may be connected to the first node N1, which may be the anode of the silicon controlled rectifier 41b.

The third n+ region n3 may surround the second p-well PW2 on the deep n-well DNW and may be connected to the first node N1. A fourth p+ region p4 may surround the first transistor M1 on the second p-well PW2, and may be connected to the sixth p+ region p6, which may be the drain of the second transistor M2. The fourth n+ region n4, the fifth n+ region n5 and the corresponding gate may be included in the first transistor M1. A sixth n+ region n6 may surround the second transistor M2 on the second n-well NW2 and may be connected to the first node N1. The fifth p+ region p5, a sixth p+ region p6 and the corresponding gate may be included in the second transistor M2.

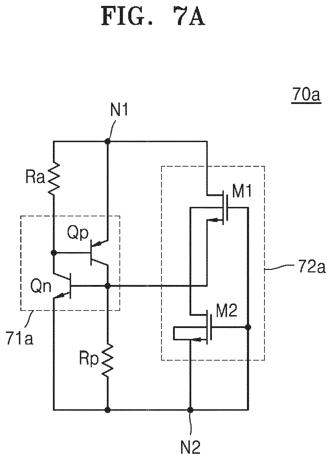

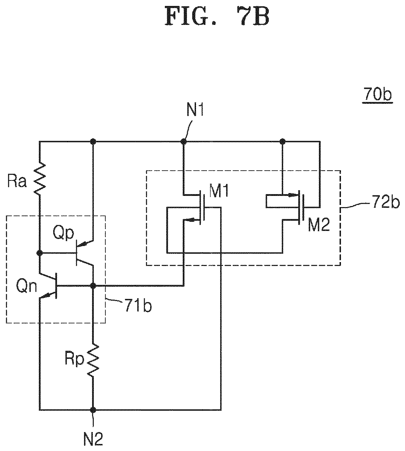

FIGS. 7A and 7B are circuit diagrams showing examples of devices according to exemplary embodiments. For example, the circuit diagrams of FIGS. 7A and 7B respectively show devices 70a and 70b that may provide protection from electrostatic discharge by forming a current path between the first node N1 and the second node N2 when the electrostatic discharge occurs in the first node N1 or the second node N2. Hereinafter, descriptions of aspects that are substantially the same as each other with respect to FIGS. 7A and 7B,or which is redundant or duplicative of description provided above, may be omitted.

Referring to FIG. 7A, the device 70a may include a silicon controlled rectifier 71a, a trigger circuit 72a, a first resistor Ra, and a second resistor Rp. Compared to the device 40a of FIG. 4A, the device 70a of FIG. 7A may further include the second resistor Rp connected between the gate and cathode of the silicon controlled rectifier 71a. In some embodiments, the first resistor Ra and the second resistor Rp may each include a well resistor, as described with reference to FIG. 2.

The silicon controlled rectifier 71a may include a PNP bipolar transistor Qp and a NPN bipolar transistor Qn, may include an anode connected to the first node N1, and may include a cathode connected to the second node N2. The trigger circuit 72a may include the first transistor M1 and the second transistor M2, which may be NFETs. The first transistor M1 may include a drain connected to the first node N1, which may be the anode of the silicon controlled rectifier 71a, a source connected to the gate of the silicon controlled rectifier 71a, and a gate connected to the second node N2, which may be the cathode of the silicon controlled rectifier 71a. The second transistor M2 may include a drain connected to the body of the first transistor M1, and a source and a gate which are connected to the cathode of the silicon controlled rectifier 71a. The second transistor M2 may limit the body current of the first transistor M1, and accordingly, the trigger voltage may be lowered and the leakage current through the substrate may be blocked by the drain-body reverse bond.

Referring to FIG. 7B, the device 70b may include a silicon controlled rectifier 71b, a trigger circuit 72b, the first resistor Ra, and the second resistor Rp. Compared to the device 70a of FIG. 7A, the second transistor M2 may be a PFET in the device 70b of FIG. 7B. The second transistor M2 may include a drain connected to a body of the first transistor M1, and a source and a gate which are connected to the anode of the silicon controlled rectifier 71b. The second transistor M2 may limit the body current of the first transistor M1, and accordingly, the trigger voltage may be lowered and the leakage current through the substrate may be blocked by the drain-body reverse bond.

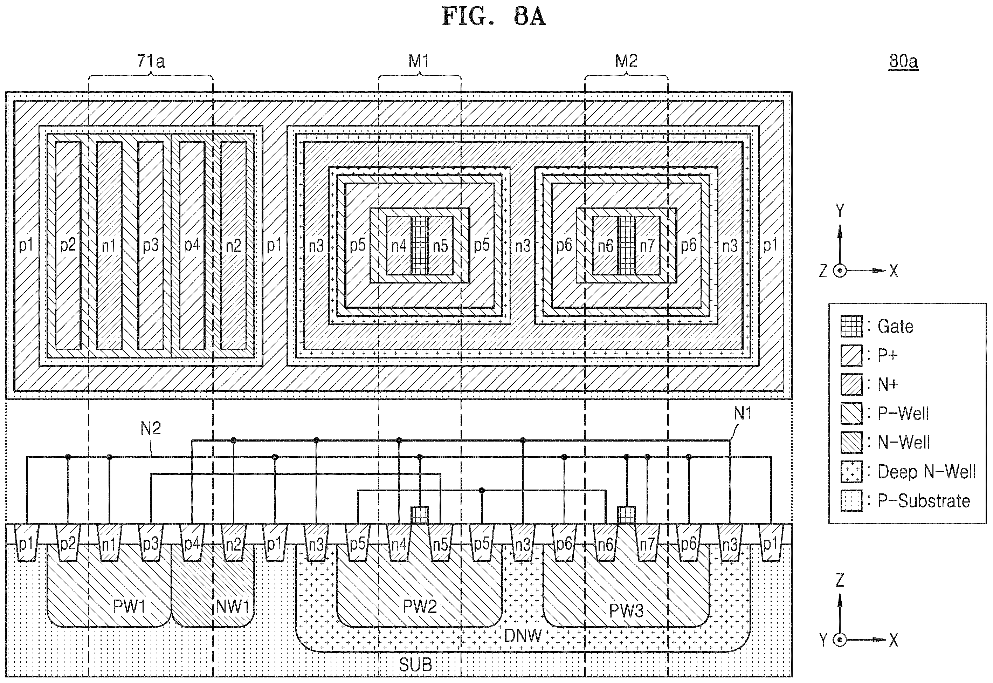

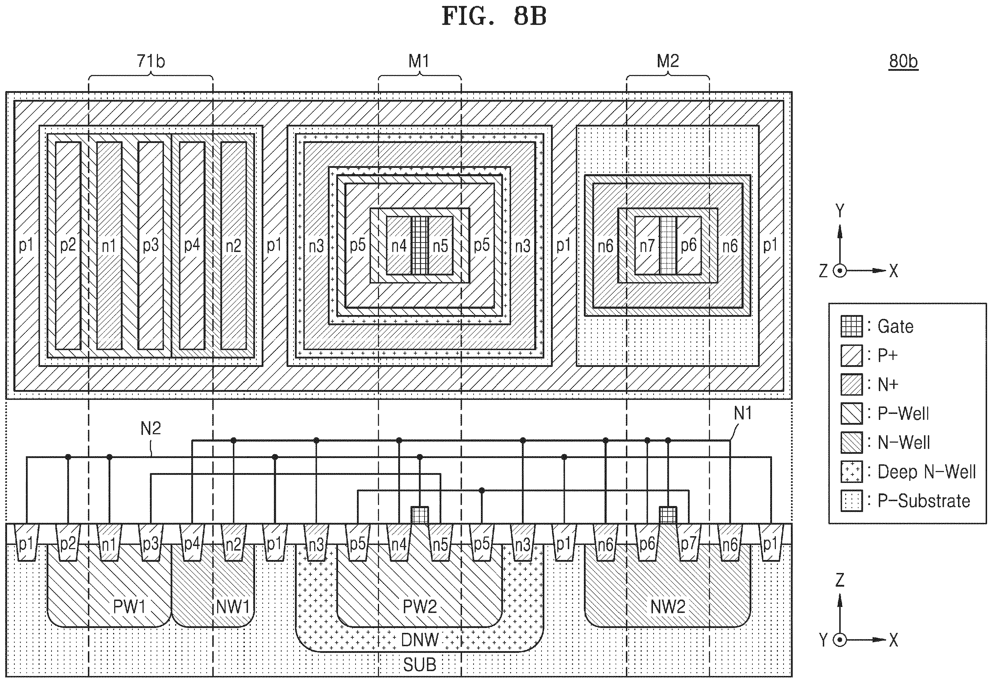

FIGS. 8A and 8B are diagrams showing examples of layouts of devices according to exemplary embodiments. For example, FIG. 8A shows a plan view and a cross-sectional view of a layout 80a corresponding to the device 70a of FIG. 7A, and FIG. 8B shows a plan view and a cross-sectional view of a layout 80b corresponding to the device 70b of FIG. 7B. For convenience of illustration in FIGS. 8A and 8B, contacts and patterns for connecting the p+ regions, the n+ regions, and the gates with one another may be omitted. The devices 70a and 70b of FIGS. 7A and 7B are not limited to the layouts 80a and 80b of FIGS. 8A and 8B. Hereinafter, FIG. 8A will be described with reference to FIG. 7A, and FIG. 8B will be described with reference to FIG. 7B.

Referring to FIG. 8A, a first p-well PW1, a first n-well NW1, and a deep n-well DNW may be disposed in the substrate SUB. In addition, a second p-well PW2 and a third p-well PW3 may be disposed in the deep n-well DNW. The first p+ region p1 may surround each of the silicon controlled rectifier 71a and the deep n-well DNW on the substrate SUB, and may be connected to the second node N2, which may be the cathode of the silicon controlled rectifier 41a. The second p+ region p2 may correspond to a resistor of the first p-well PW1, which may be an end of the resistor Rp, and may be connected to the second node N2. The first n+ region n1, the third p+ region p3, the fourth p+ region p4, the first p-well PW1 and the first n-well NW1 may be included in the silicon controlled rectifier 71a. The third p+ region p3 may be connected to the fifth n+ region n5, which may be the source of the first transistor M1. The second n+ region n2 may correspond to a resistor of the first n-well NW1, which may be an end of the resistor Ra, and may be connected to the first node N1, which may be the anode of the silicon controlled rectifier 71a.

The third n+ region n3 may surround each of the second p-well PW2 and the third p-well PW3 on the deep n-well DNW, and may be connected to the first node N1. The fifth p+ region p5 may surround the first transistor M1 on the second p-well PW2, and may be connected to the sixth n+ region n6, which may be the drain of the second transistor M2. The fourth n+ region n4, the fifth n+ region n5 and the corresponding gate may be included in the first transistor M1. A sixth p+ region p6 may surround the second transistor M2 on the third p-well PW3 and may be connected to the second node N2. The sixth n+ region n6, a seventh n+ region n7 and the corresponding gate may be included in the second transistor M2.

Referring to FIG. 8B, the first p-well PW1, the first n-well NW1, the deep n-well DNW, and the second n-well NW2 may be disposed in the substrate SUB. In addition, the second p-well PW2 may be disposed in the deep n-well DNW. The first p+ region p1 may surround each of the silicon controlled rectifier 71b, the deep n-well DNW, and the second n-well NW2 on the substrate SUB, and may be connected to the second node N2, which may be the cathode of the silicon controlled rectifier 71b. The second p+ region p2 may correspond to the resistor of the first p-well PW1, which may be an end of the resistor Rp, and may be connected to the second node N2. The first n+ region n1, the third p+ region p3, the fourth p+ region p4, the first p-well PW1 and the first n-well NW1 may be included in the silicon controlled rectifier 71b. The third p+ region p3 may be connected to the fifth n+ region n5, which may be the source of the first transistor M1. The second n+ region n2 may correspond to the resistor of the first n-well NW1, which may be an end of the resistor Ra, and may be connected to the first node N1, which may be the anode of the silicon controlled rectifier 71b.

The third n+ region n3 may surround the second p-well PW2 on the deep n-well DNW and may be connected to the first node N1. The fifth p+ region p5 may surround the first transistor M1 on the second p-well PW2, and may be connected to the seventh p+ region p7, which may be the drain of the second transistor M2. The fourth n+ region n4, the fifth n+ region n5 and the corresponding gate may be included in the first transistor M1. The sixth n+ region n6 may surround the second transistor M2 on the second n-well NW2 and may be connected to the first node N1. A sixth p+ region p6, the seventh p+ region p7 and the corresponding gate may be included in the second transistor M2.

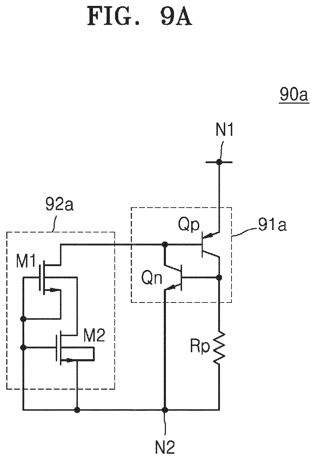

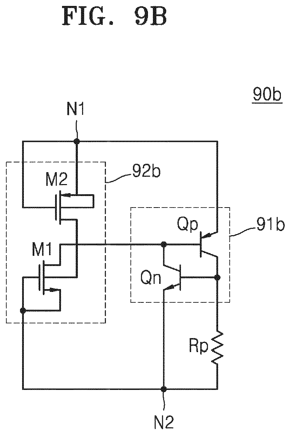

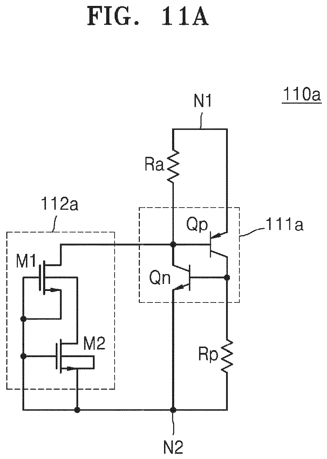

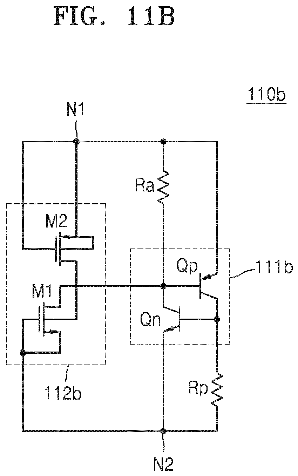

FIGS. 9A and 9B are circuit diagrams showing examples of devices according to exemplary embodiments. For example, the circuit diagrams of FIGS. 9A and 9B show devices 90a and 90b that may provide protection from electrostatic discharge by forming a current path between the first node N1 and the second node N2 when the electrostatic discharge occurs in the first node N1 or the second node N2. In the devices of FIGS. 4A, 4B, 7A, and 7B, the trigger circuit may provide a trigger current to the silicon controlled rectifier, and, in the devices described below with reference to FIGS. 9A, 9B, 11A, and 11B, the trigger circuit may draw a trigger current from the silicon controlled rectifier. Hereinafter, descriptions of aspects that are substantially the same as each other with respect to FIGS. 9A and 9B,or which is redundant or duplicative of description provided above, may be omitted.

Referring to FIG. 9A, the device 90a may include a silicon controlled rectifier 91a, a trigger circuit 92a, and the resistor Rp. In some embodiments, the resistor Rp may include a well resistor, as described with reference to FIG. 2. The silicon controlled rectifier 91a may include the PNP bipolar transistor Qp and the NPN bipolar transistor Qn, may include an anode connected to the first node N1, and may include a cathode connected to the second node N2. The trigger circuit 92a may include the first transistor M1 and the second transistor M2, which may be NFETs. The first transistor M1 may include a drain connected to the base of the PNP bipolar transistor Qp and the collector of the NPN bipolar transistor Qn, and a source and a gate which are connected to the second node N2, which may be the cathode of the silicon controlled rectifier 91a. The second transistor M2 may include a drain connected to the body of the first transistor M1, and a source and a gate which are connected to the cathode of the silicon controlled rectifier 91a. The second transistor M2 may limit the body current of the first transistor M1, and accordingly, the trigger voltage may be lowered and the leakage current through the substrate may be blocked by the drain-body reverse bond.

Referring to FIG. 9B, the device 90b may include a silicon controlled rectifier 91b, a trigger circuit 92b, and the resistor Rp. Compared to the device 90a of FIG. 9A, the second transistor M2 may be a PFET in the device 90b of FIG. 9B. The second transistor M2 may include a drain connected to a body of the first transistor M1, and a source and a gate which are connected to the anode of the silicon controlled rectifier 91b. The second transistor M2 may limit the body current of the first transistor M1, and accordingly, the trigger voltage may be lowered and the leakage current through the substrate may be blocked by the drain-body reverse bond.

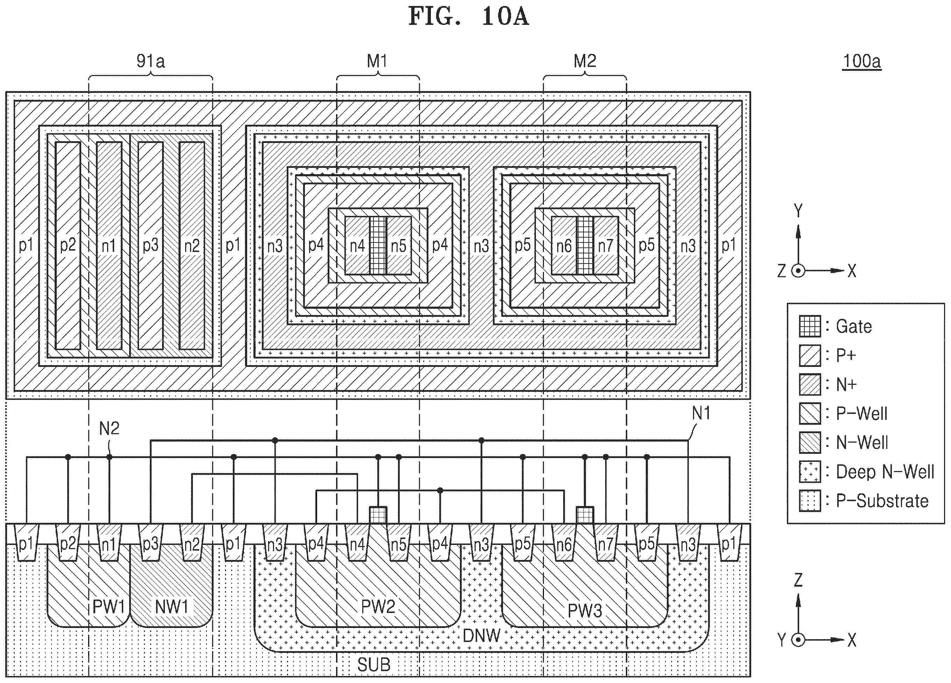

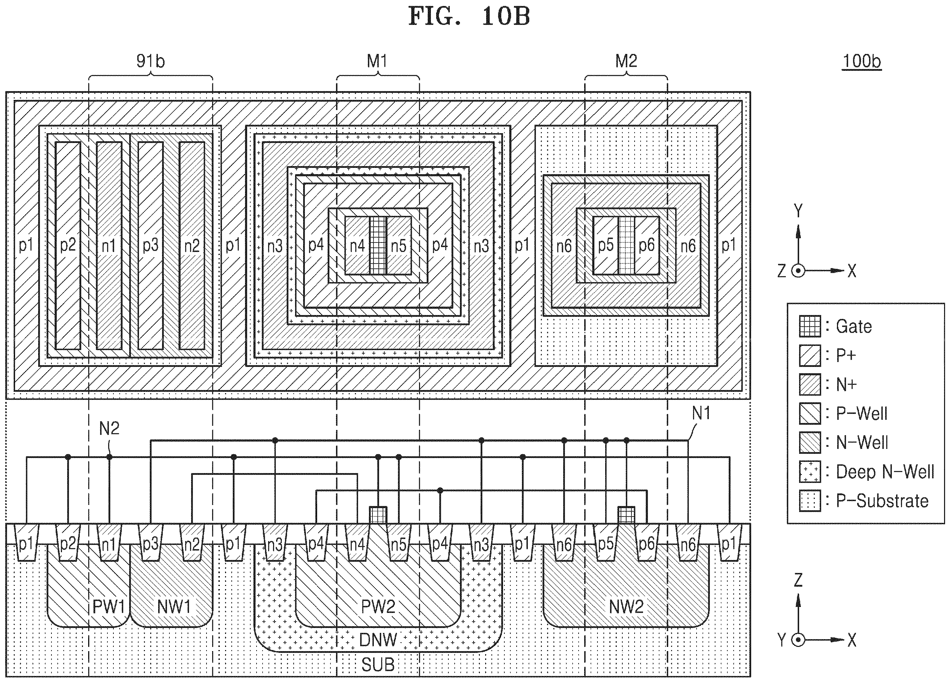

FIGS. 10A and 10B are diagrams showing examples of layouts of devices according to exemplary embodiments. For example, FIG. 10A shows a plan view and a cross-sectional view of a layout 100a corresponding to the device 90a of FIG. 9A, and FIG. 10B shows a plan view and a cross-sectional view of a layout 100b corresponding to the device 90b of FIG. 9B. For convenience of illustration in FIGS. 10A and 10B, contacts and patterns for connecting the p+ regions, the n+ regions, and the gates with one another may be omitted. The devices 90a and 90b of FIGS. 9A and 9B are not limited to the layouts 100a and 100b of FIGS. 10A and 10B. Hereinafter, FIG. 10A will be described with reference to FIG. 9A, and FIG. 10B will be described with reference to FIG. 9B.

Referring to FIG. 10A, the first p-well PW1, the first n-well NW1, and the deep n-well DNW may be disposed in the substrate SUB. In addition, the second p-well PW2 and the third p-well PW3 may be disposed in the deep n-well DNW. The first p+ region p1 may surround each of the silicon controlled rectifier 91a and the deep n-well DNW on the substrate SUB, and may be connected to the second node N2, which may be the cathode of the silicon controlled rectifier 91a. The second p+ region p2 may correspond to the resistor of the first p-well PW1, which may be an end of the resistor Rp, and may be connected to the second node N2. The first n+ region n1, the third p+ region p3, the second n+ region n2, the first p-well PW1 and the first n-well NW1 may be included in the silicon controlled rectifier 91a. The second n+ region n2 may be connected to the fourth n+ region n4, which may be the drain of the first transistor M1.

The third n+ region n3 may surround each of the second p-well PW2 and the third p-well PW3 on the deep n-well DNW, and may be connected to the first node N1. The fourth p+ region p4 may surround the first transistor M1 on the second p-well PW2, and may be connected to the sixth n+ region n6, which may be the drain of the second transistor M2. The fourth n+ region n4, the fifth n+ region n5 and the corresponding gate may be included in the first transistor M1. The fifth p+ region p5 may surround the second transistor M2 on the third p-well PW3 and may be connected to the second node N2. The sixth n+ region n6, a seventh n+ region n7 and the corresponding gate may be included in the second transistor M2.

Referring to FIG. 10B, the first p-well PW1, the first n-well NW1, the deep n-well DNW, and the second n-well NW2 may be disposed in the substrate SUB. In addition, the second p-well PW2 may be disposed in the deep n-well DNW. The first p+ region p1 may surround each of the silicon controlled rectifier 91b, the deep n-well DNW, and the second n-well NW2 on the substrate SUB, and may be connected to the second node N2, which may be the cathode of the silicon controlled rectifier 91b. The second p+ region p2 may correspond to the resistor of the first p-well PW1, which may be an end of the resistor Rp, and may be connected to the second node N2. The first n+ region n1, the third p+ region p3, the second n+ region n2, the first p-well PW1 and the first n-well NW1 may be included in the silicon controlled rectifier 91a. The second n+ region n2 may be connected to the fourth n+ region n4, which may be the drain of the first transistor M1.

The third n+ region n3 may surround the second p-well PW2 on the deep n-well DNW and may be connected to the first node N1. The fourth p+ region p4 may surround the first transistor M1 on the second p-well PW2, and may be connected to the sixth p+ region p6, which may be the drain of the second transistor M2. The fourth n+ region n4, the fifth n+ region n5 and the corresponding gate may be included in the first transistor M1. The sixth n+ region n6 may surround the second transistor M2 on the second n-well NW2 and may be connected to the first node N1. A fifth p+ region p5, the sixth p+ region p6 and the corresponding gate may be included in the second transistor M2.

FIGS. 11A and 11B are circuit diagrams showing examples of devices according to exemplary embodiments. For example, the circuit diagrams of FIGS. 11A and 11B show devices 110a and 110b that may provide protection from electrostatic discharge by forming a current path between the first node N1 and the second node N2 when the electrostatic discharge occurs in the first node N1 or the second node N2. Hereinafter, descriptions of aspects that are substantially the same as each other with respect to FIGS. 11A and 11B,or which is redundant or duplicative of description provided above, may be omitted.

Referring to FIG. 11A, the device 110a may include a silicon controlled rectifier 111a, a trigger circuit 112a, the first resistor Ra, and the second resistor Rp. Compared to the device 90a of FIG. 9A, the device 110a of FIG. 11A may further include the first resistor Ra connected between the emitter and the base of the PNP bipolar transistor Qp. In some embodiments, the first resistor Ra and the second resistor Rp may each include a well resistor, as described with reference to FIG. 2.

The silicon controlled rectifier 111a may include the PNP bipolar transistor Qp and the NPN bipolar transistor Qn, may include an anode connected to the first node N1, and may include a cathode connected to the second node N2. The trigger circuit 112a may include the first transistor M1 and the second transistor M2, which may be NFETs. The first transistor M1 may include a drain connected to the base of the PNP bipolar transistor Qp and the collector of the NPN bipolar transistor Qn, and a source and a gate which are connected to the second node N2, which may be the cathode of the silicon controlled rectifier 111a. The second transistor M2 may include a drain connected to the body of the first transistor M1, and a source and a gate which are connected to the cathode of the silicon controlled rectifier 111a. The second transistor M2 may limit the body current of the first transistor M1, and accordingly, the trigger voltage may be lowered and the leakage current through the substrate may be blocked by the drain-body reverse bond.

Referring to FIG. 11B, the device 110b may include a silicon controlled rectifier 111b, a trigger circuit 112b, the first resistor Ra and the second resistor Rp. Compared to the device 110a of FIG. 11A, the second transistor M2 may be a PFET in the device 110b of FIG. 11B. The second transistor M2 may include a drain connected to a body of the first transistor M1, and a source and a gate which are connected to the anode of the silicon controlled rectifier 111b. The second transistor M2 may limit the body current of the first transistor M1, and accordingly, the trigger voltage may be lowered and the leakage current through the substrate may be blocked by the drain-body reverse bond.

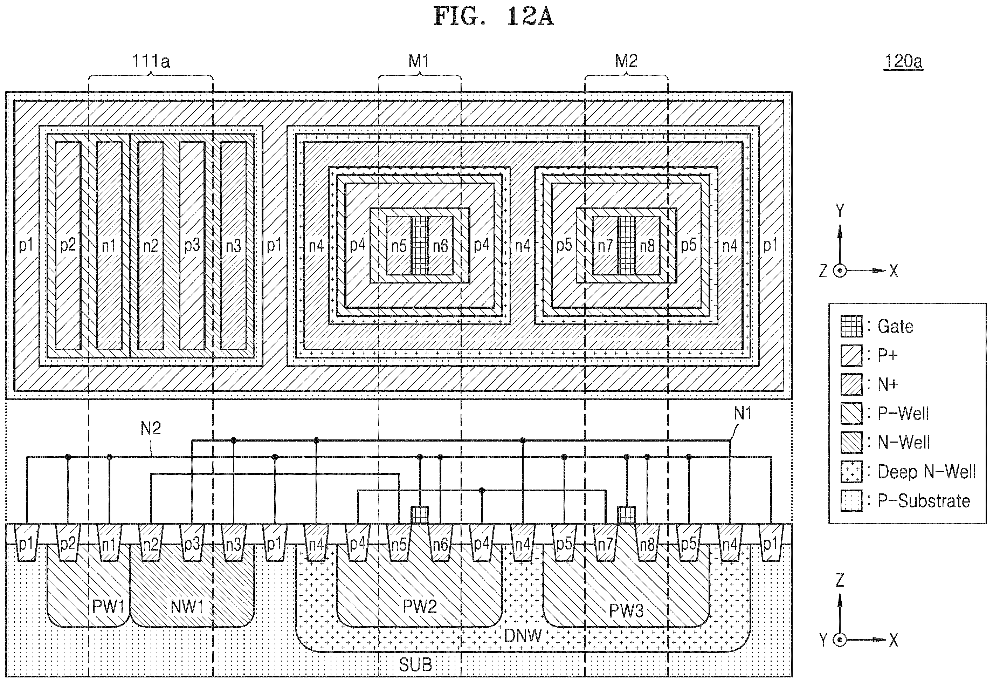

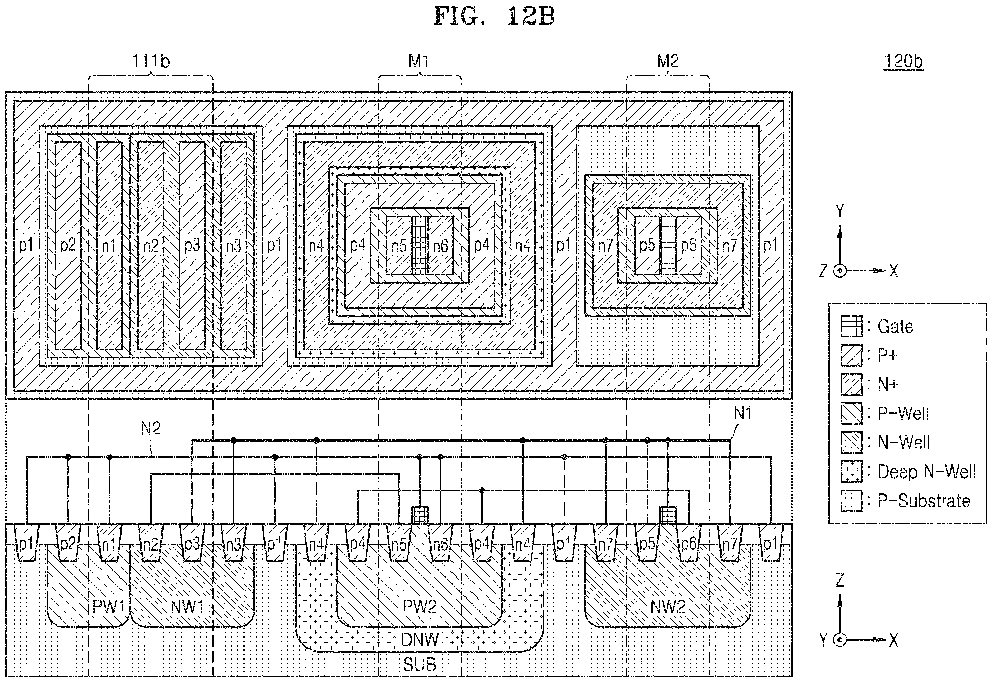

FIGS. 12A and 12B are diagrams showing examples of layouts of devices according to exemplary embodiments. For example, FIG. 12A shows a plan view and a cross-sectional view of a layout 120a corresponding to the device 110a of FIG. 11A, and FIG. 12B shows a plan view and a cross-sectional view of a layout 120b corresponding to the device 110b of FIG. 11B. For convenience of illustration in FIGS. 12A and 12B, contacts and patterns for connecting the p+ regions, the n+ regions, and the gates with one another may be omitted. The devices 110a and 110b of FIGS. 11A and 11B are not limited to the layouts 120a and 120b of FIGS. 12A and 12B. Hereinafter, FIG. 12A will be described with reference to FIG. 11A, and FIG. 12B will be described with reference to FIG. 11B.

Referring to FIG. 12A, the first p-well PW1, the first n-well NW1, and the deep n-well DNW may be disposed in the substrate SUB. In addition, the second p-well PW2 and the third p-well PW3 may be disposed in the deep n-well DNW. The first p+ region p1 may surround each of the silicon controlled rectifier 111a and the deep n-well DNW on the substrate SUB, and may be connected to the second node N2, which may be the cathode of the silicon controlled rectifier 111a. The second p+ region p2 may correspond to the resistor of the first p-well PW1, which may be an end of the second resistor Rp, and may be connected to the second node N2. The first n+ region n1, the second n+ region n2, the third p+ region p3, the first p-well PW1 and the first n-well NW1 may be included in the silicon controlled rectifier 111a. The second n+ region n2 may be connected to the fifth n+ region n5, which may be the drain of the first transistor M1. The third n+ region n3 may be connected to the resistor of the first p-well PW1, which may be an end of the first resistor Ra, and may be connected to the first node N1.

The fourth n+ region n4 may surround each of the second p-well PW2 and the third p-well PW3 on the deep n-well DNW, and may be connected to the first node N1. The fourth p+ region p4 may surround the first transistor M1 on the second p-well PW2, and may be connected to the seventh n+ region n7, which may be the drain of the second transistor M2. The fifth n+ region n5, the sixth n+ region n6 and the corresponding gate may be included in the first transistor M1. The fifth p+ region p5 may surround the second transistor M2 on the third p-well PW3 and may be connected to the second node N2. The seventh n+ region n7, an eighth n+ region n8 and the corresponding gate may be included in the second transistor M2.

Referring to FIG. 12B, the first p-well PW1, the first n-well NW1, the deep n-well DNW, and the second n-well NW2 may be disposed in the substrate SUB. In addition, the second p-well PW2 may be disposed in the deep n-well DNW. The first p+ region p1 may surround each of the silicon controlled rectifier 111b, the deep n-well DNW, and the second n-well NW2 on the substrate SUB, and may be connected to the second node N2, which may be the cathode of the silicon controlled rectifier 111b. The second p+ region p2 may correspond to the resistor of the first p-well PW1, which may be an end of the second resistor Rp, and may be connected to the second node N2. The first n+ region n1, the second n+ region n2, the third p+ region p3, the first p-well PW1 and the first n-well NW1 may be included in the silicon controlled rectifier 111b. The second n+ region n2 may be connected to the fifth n+ region n5, which may be the drain of the first transistor M1. The third n+ region n3 may correspond to the resistor of the first p-well PW1, which may be an end of the first resistor Ra, and may be connected to the first node N1.

The fourth n+ region n4 may surround the second p-well PW2 on the deep n-well DNW and may be connected to the first node N1. The fourth p+ region p4 may surround the first transistor M1 on the second p-well PW2, and may be connected to the sixth p+ region p6, which may be the drain of the second transistor M2. The fifth n+ region n5, the sixth n+ region n6 and the corresponding gate may be included in the first transistor M1. The seventh n+ region n7 may surround the second transistor M2 on the second n-well NW2 and may be connected to the first node N1. A fifth p+ region p5, the sixth p+ region p6 and the corresponding gate may be included in the second transistor M2.

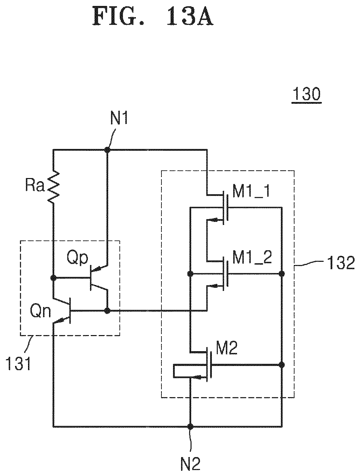

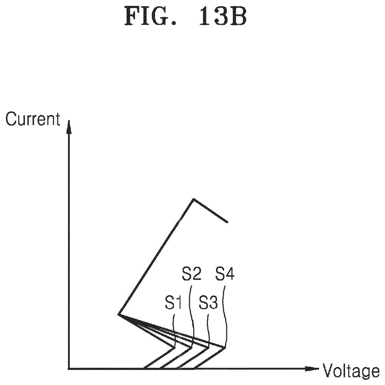

FIG. 13A is a circuit diagram of a device 130 according to an example embodiment, and FIG. 13B is a graph showing the characteristics of the device 130 according to an example embodiment. For example, the circuit diagram of FIG. 13A shows the device 130 which may provide protection from electrostatic discharge by forming a current path between the first node N1 and the second node N2 when the electrostatic discharge occurs in the first node N1 or the second node N2, and FIG. 13B shows first to fourth snapback curves S1 to S4 corresponding to the device 130 of FIG. 13A. Description of aspects of FIGS. 13A and 13B which is redundant or duplicative of description provided above may be omitted.

Referring to FIG. 13A, the device 130 may include a silicon controlled rectifier 131, a trigger circuit 132, and the resistor Ra. The silicon controlled rectifier 131 may include the PNP bipolar transistor Qp and the NPN bipolar transistor Qn, may include an anode connected to the first node N1, and may include a cathode connected to the second node N2. The trigger circuit 132 may include two first transistors M1_1 and M1_2 and the second transistor M2, which may be NFETs. When compared to the device 40a of FIG. 4A, the trigger circuit 132 in the device 130 of FIG. 13A may include a plurality of first transistors that are in serial connection with each other. As shown in FIG. 13A, two first transistors M1_1 and M1_2 may each include bodies that are commonly connected to the drain of the second transistor M2.

In some embodiments, the trigger circuit 132 may include more than two first transistors to control the trigger voltage. For example, as shown in FIG. 13B, when the trigger circuit 132 includes one first transistor, the trigger voltage may occur at a low voltage as shown in the first snapback curve S1, and accordingly, the trigger voltage may be low. When the trigger circuit 132 includes two to four first transistors, as shown in the second to fourth snapback curves S2 to S4, respectively, the voltage at which the trigger circuit occurs may increase, and accordingly, the trigger voltage may also increase. In some embodiments, the trigger circuits of FIGS. 4B, 7A, 7B, 9A, 9B, 11A, and 11B may also include at least two first transistors in serial connection with each other.

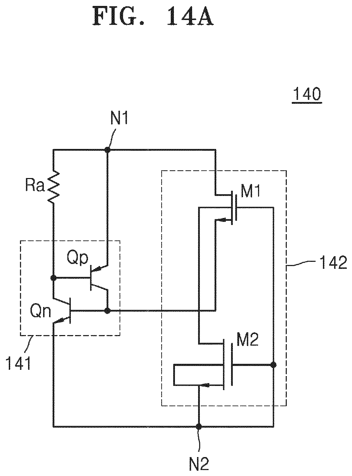

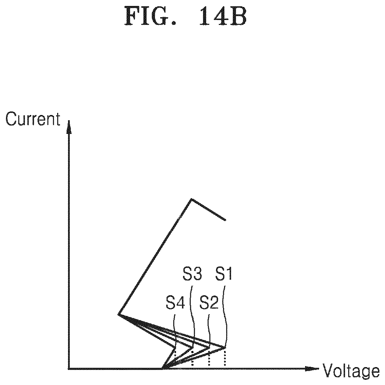

FIG. 14A is a circuit diagram of a device 140 according to an example embodiment, and FIG. 14B is a graph showing the characteristics of the device 140 according to an example embodiment. For example, the circuit diagram of FIG. 14A shows the device 140 which may provide protection from electrostatic discharge by forming a current path between the first node N1 and the second node N2 when the electrostatic discharge occurs in the first node N1 or the second node N2, and FIG. 14B shows snapback curves S1 to S4 corresponding to the device 140 of FIG. 14A. Description of aspects of FIGS. 14A and 14B which is redundant or duplicative of description provided above may be omitted.

Referring to FIG. 14A, the device 140 may include a silicon controlled rectifier 141, a trigger circuit 142, and a resistor Ra. The silicon controlled rectifier 141 may include the PNP bipolar transistor Qp and the NPN bipolar transistor Qn, may include an anode connected to the first node N1, and may include a cathode connected to the second node N2. The trigger circuit 142 may include the first transistor M1 and the second transistor M2, which may be NFETs. When compared to the device 40a of FIG. 4A, the trigger circuit 132 in the device 140 of FIG. 14A may include the second transistor M2 having an adjusted size.

In some embodiments, the trigger circuit 142 may include the second transistor M2 having an adjusted size, for example, an adjusted channel width, to control the body current of the first transistor M1. A source resistor of the first transistor M1 or a base resistor of the NPN bipolar transistor Qn may be inversely proportional to a reverse junction resistance of the second transistor M2, and accordingly, the body current of the first transistor M1 may be controlled through the channel width of the second transistor M2. For example, as shown in FIG. 14B, as the channel width of the second transistor M2 is increased, the trigger voltage may be decreased as shown in the first to fourth snapback curves S1 to S4. In some embodiments, the trigger circuits of FIGS. 4B, 7A, 7B, 9A, 9B, 11A, and 11B may also include second transistors that have adjusted sizes. In an example, a channel width of the second transistor may be different from a channel width of the first transistor.

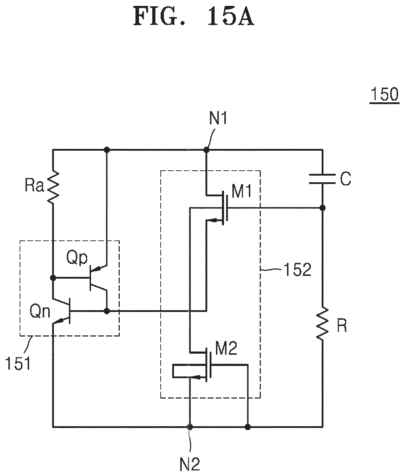

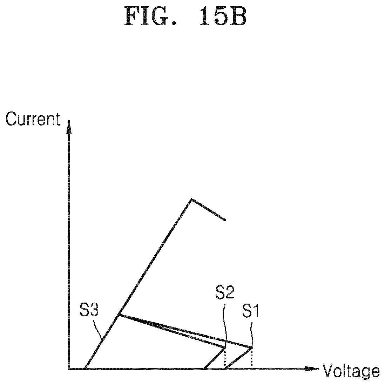

FIG. 15A is a circuit diagram showing a device 150 according to an example embodiment, and FIG. 15B is a graph showing the characteristics of the device 150 according to an example embodiment. For example, the circuit diagram of FIG. 15A shows the device 150 which may provide protection from electrostatic discharge by forming a current path between the first node N1 and the second nodeN2 when the electrostatic discharge occurs in the first node N1 or the second node N2, and FIG. 15B shows snapback curves S1 to S3 corresponding to the device 150 of FIG. 15A. Description of aspects of FIGS. 15A and 15B which is redundant or duplicative of description provided above may be omitted.

Referring to FIG. 15A, the device 150 may include a silicon controlled rectifier 151, a trigger circuit 152, the first resistor Ra, a capacitor C, and a second resistor R. The silicon controlled rectifier 151 may include the PNP bipolar transistor Qp and the NPN bipolar transistor Qn, may include an anode connected to the first node N1, and may include a cathode connected to the second node N2. The trigger circuit 152 may include the first transistor M1 and the second transistor M2, which may be NFETs. Compared to the device 40a of FIG. 4A, the device 150 of FIG. 15A may further include the capacitor C and the second resistor R, which are connected to the gate of the first transistor M1. The capacitor C may be connected between the first node N1, which may be the anode of the silicon controlled rectifier 151, and the gate of the first transistor M1. The second resistor R may be connected between the gate of the first transistor M1 and the second node N2, which may be the cathode of the silicon controlled rectifier 151. Accordingly, the first transistor M1 may operate like a gate-coupled n-channel metal-oxide semiconductor (GCNMOS).

In some embodiments, the capacitor C and the second resistor R may be used to control the trigger voltage. For example, the trigger voltage may depend on a capacitance of the capacitor C and a time constant according to a resistance of the second resistor R. Accordingly, as shown in FIG. 15B, as the time constant is increased, the more the trigger voltage may be reduced, as shown in in first to third snapback curves S1 to S3. In some embodiments, the devices of FIGS. 4B, 7A, 7B, 9A, 9B, 11A, and 11B may also include a capacitor and a resistor, which are connected to the gate of the first transistor.

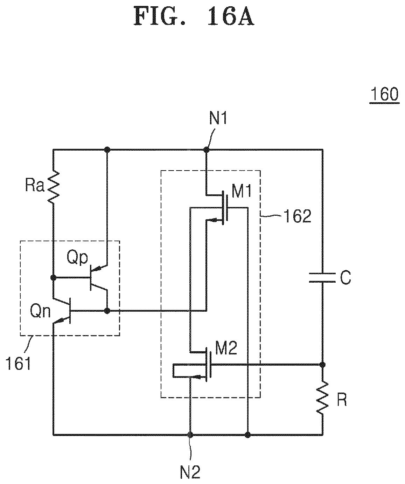

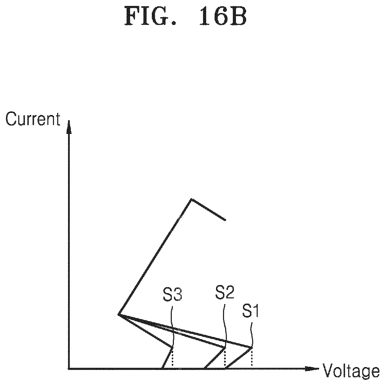

FIG. 16A is a circuit diagram showing a device 160 according to an example embodiment, and FIG. 16B is a graph showing the characteristics of the device 160 according to an example embodiment. For example, the circuit diagram of FIG. 16A shows the device 160 which may provide protection from electrostatic discharge by forming a current path between the first node N1 and the second node N2 when the electrostatic discharge occurs in the first node N1 or the second node N2, and FIG. 16B shows snapback curves S1 to S3 corresponding to the device 160 of FIG. 16A. Description of aspects of FIGS. 16A and 16B which is redundant or duplicative of description provided above may be omitted.

Referring to FIG. 16A, the device 160 may include a silicon controlled rectifier 161, a trigger circuit 162, the first resistor Ra, the capacitor C, and the second resistor R. The silicon controlled rectifier 161 may include the PNP bipolar transistor Qp and the NPN bipolar transistor Qn, may include an anode connected to the first node N1, and may include a cathode connected to the second node N2. The trigger circuit 162 may include the first transistor M1 and the second transistor M2, which may be NFETs. Compared to the device 40a of FIG. 4A, the device 160 of FIG. 16A may further include the capacitor C and the second resistor R, which are connected to the gate of the second transistor M2. The capacitor C may be connected between the first node N1, which may be the anode of the silicon controlled rectifier 161, and the gate of the second transistor M2. The second resistor R may be connected between the gate of the second transistor M2 and the second node N2, which may be the cathode of the silicon controlled rectifier 161. Accordingly, the second transistor M2 may operate like a GCNMOS.

In some embodiments, the capacitor C and the second resistor R may be used to control the trigger voltage. For example, the trigger voltage may depend on the capacitance of the capacitor C and the time constant according to the resistance of the second resistor R. Accordingly, as shown in FIG. 16B, the more the time constant is increased, the more the trigger voltage is reduced, as shown in first to third snapback curves S1 to S3. In some embodiments, the devices of FIGS. 4B, 7A, 7B, 9A, 9B, 11A, and 11B may also include the capacitor and the resistor, which are connected to the gate of the second transistor.

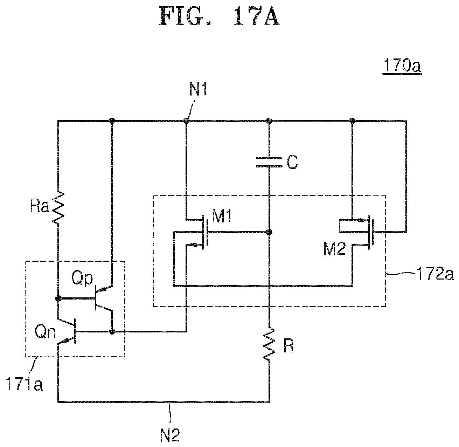

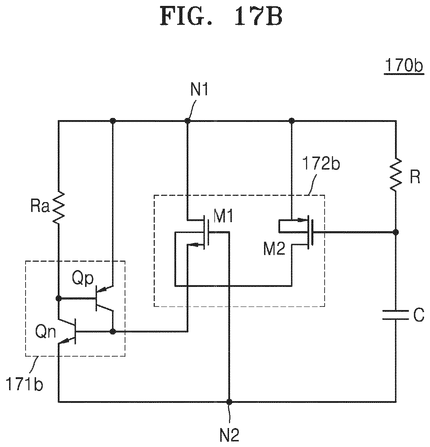

FIGS. 17A and 17B are circuit diagrams showing examples of devices according to exemplary embodiments. For example, the circuit diagrams of FIGS. 17A and 17B show devices 170a and 170b that may provide protection from electrostatic discharge by forming a current path between the first node N1 and the second node N2 when the electrostatic discharge occurs in the first node N1 or the second node N2. Description of aspect of FIGS. 17A and 17B which is redundant or duplicative of description provided above may be omitted.

Referring to FIG. 17A, the device 170a may include a silicon controlled rectifier 171a, a trigger circuit 172a, the first resistor Ra, the capacitor C, and the second resistor R. The silicon controlled rectifier 171a may include a PNP bipolar transistor Qp and a NPN bipolar transistor Qn, may include an anode connected to the first node N1, and may include a cathode connected to the second node N2. The trigger circuit 172a may include the first transistor M1, which may be a NFET, and the second transistor M2, which may be a PFET. Compared to the device 150 of FIG. 15A, the device 170a of FIG. 17A may include the second transistor M2, which is a PFET. The capacitor C may be connected between the first node N1, which may be the anode of the silicon controlled rectifier 171a, and the gate of the first transistor M1. The second resistor R may be connected between the gate of the first transistor M1 and the second node N2, which may be the cathode of the silicon controlled rectifier 171a. Accordingly, the first transistor M1 may operate like a GCNMOS, and, as described with reference to FIG. 15A, the trigger voltage may be controlled.

Referring to FIG. 17B, the device 170b may include a silicon controlled rectifier 171b, a trigger circuit 172b, the first resistor Ra, the capacitor C, and the second resistor R. The silicon controlled rectifier 171b may include a PNP bipolar transistor Qp and an NPN bipolar transistor Qn, may include an anode connected to the first node N1, and may include a cathode connected to the second node N2. The trigger circuit 172b may include the first transistor M1, which may be a NFET, and the second transistor M2, which may be a PFET. Compared to the device 150 of FIG. 15A, the device 170b of FIG. 17B may include the second transistor M2, which is a PFET. The capacitor C may be connected between the second node N2, which may be the cathode of the silicon controlled rectifier 171b, and the gate of the second transistor M2. The second resistor R may be connected between the gate of the second transistor M2 and the first node N1, which may be the anode of the silicon controlled rectifier 171b. Accordingly, the second transistor M2 may operate like a GCNMOS, and, as described with reference to FIG. 16A, the trigger voltage may be controlled.

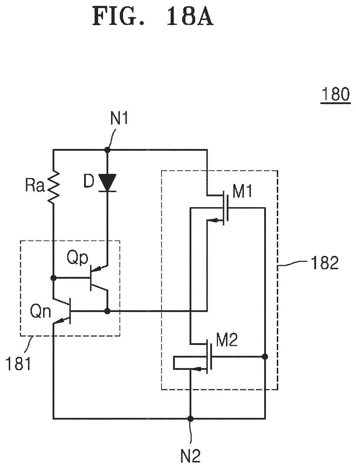

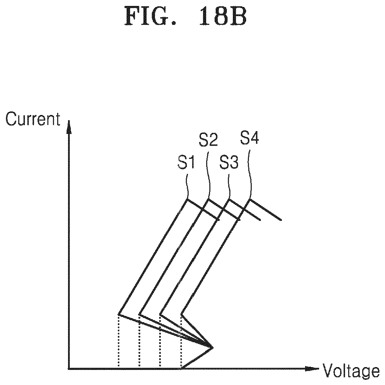

FIG. 18A is a circuit diagram of a device 180 according to an example embodiment, and FIG. 18B is a graph showing the characteristics of the device 180 according to an example embodiment. For example, the circuit diagram of FIG. 18A shows the device 180 which may provide protection from electrostatic discharge by forming a current path between the first node N1 and the second node N2 when the electrostatic discharge occurs in the first node N1 or the second node N2, and FIG. 18B shows snapback curves S1 to S4 corresponding to the device 180 of FIG. 18A. Description of aspects of FIGS. 18A and 18B which is redundant or duplicative of description provided above may be omitted.

Referring to FIG. 18A, the device 180 may include a silicon controlled rectifier 181, a trigger circuit 182, the resistor Ra, and a diode D. The silicon controlled rectifier 181 may include a PNP bipolar transistor Qp and an NPN bipolar transistor Qn, may include an anode connected to the first node N1, and may include a cathode connected to the second node N2. The trigger circuit 182 may include the first transistor M1 and the second transistor M2, which may be NFETs. Compared to the device 40a of FIG. 4A, the device 180 of FIG. 18A may further include the diode D connected between the first node N1 and the anode of the silicon controlled rectifier 181. In some embodiments, the device 180 may include two or more diodes in serial connection with each other between the first node N1 and the anode of the silicon controlled rectifier 181.

In some embodiments, at least one diode may be added to the discharge path to control the bipolar hold voltage. For example, the bipolar hold voltage may correspond to the sum of a base-collector voltage of the NPN anode transistor Qn, an emitter-collector voltage of the PNP bipolar transistor Qp, and a forward voltage of at least one diode. Accordingly, as shown in FIG. 18B, as the number of diodes is increased, the bipolar hold voltage may be increased as shown in first to fourth snapback curves S1 to S4. In some embodiments, the devices of FIGS. 4B, 7A, 7B, 9A, 9B, 11A, and 11B may also include at least one diode connected between the first node N1 and the anode of the silicon controlled rectifier.

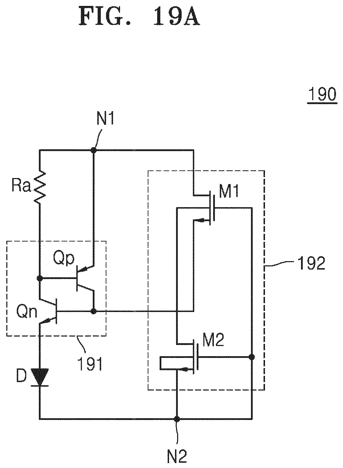

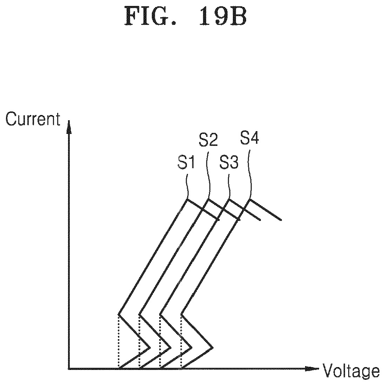

FIG. 19A is a circuit diagram of a device 190 according to an example embodiment, and FIG. 19B is a graph showing the characteristics of the device 190 according to an example embodiment. For example, the circuit diagram of FIG. 19A shows the device 190 which may provide protection from electrostatic discharge by forming a current path between the first node N1 and the second node N2 when the electrostatic discharge occurs in the first node N1 or the second node N2, and FIG. 19B shows the snapback curves S1 to S4 corresponding to the device 190 of FIG. 19A. Description of aspects of FIGS. 19A and 19B which is redundant or duplicative of description provided above may be omitted.

Referring to FIG. 19A, the device 190 may include a silicon controlled rectifier 191, a trigger circuit 192, the resistor Ra, and the diode D. The silicon controlled rectifier 191 may include the PNP bipolar transistor Qp and the NPN bipolar transistor Qn, may include an anode connected to the first node N1, and may include a cathode connected to the second node N2. The trigger circuit 192 may include the first transistor M1 and the second transistor M2, which may be NFETs. Compared to the device 40a of FIG. 4A, the device 190 of FIG. 19A may further include the diode D connected between the cathode of the silicon controlled rectifier 191 and the second node N2. In some embodiments, the device 190 may include at least two diodes that are in serial connection with each other between the cathode of the silicon controlled rectifier 191 and the second node N2.

In some embodiments, at least one diode may be added on the discharge path and the trigger current path to control the bipolar hold voltage and the trigger voltage. For example, the trigger voltage and the bipolar hold voltage may depend on a forward voltage of a diode. Accordingly, as shown in FIG. 19B, the more the number of diodes are increased, the more the bipolar hold voltage and the trigger voltage may be increased simultaneously as in the first to fourth snapback curves S1 to S4. In some embodiments, the devices of FIGS. 4B, 7A, 7B, 9A, 9B, 11A, and 11B may also include at least one diode connected between the cathode of the silicon controlled rectifier and the second node N2.

## Claims

1. A device (10, 40a, 40b, 70a, 70b) comprising:
a silicon controlled rectifier (SCR, 41a, 41b, 71a, 71b);
at least one first transistor (M1) connected between an anode of the silicon controlled rectifier (SCR, 41a, 41b, 71a, 71b) and a gate of the silicon controlled rectifier (SCR, 41a, 41b, 71a, 71b); and
a second transistor (M2), wherein a source of the second transistor (M2) is connected to one from among the anode and a cathode of the silicon controlled rectifier (SCR, 41a, 41b, 71a, 71b), and wherein a drain of the second transistor (M2) is connected to a body of the at least one first transistor (M1) **characterized in that** the drain of the second transistor is not connected to a source of the at least one first transistor (M1).

2. The device (10, 40a, 40b, 70a, 70b) of claim 1, wherein the at least one first transistor (M1) and the second transistor (M2) each comprise an n-channel field effect transistor ,NFET, and
wherein the source of the second transistor (M2) is connected to the cathode.

3. The device (10, 40a, 40b, 70a, 70b) of claim 2, wherein a gate of the at least one first transistor (M1) is connected to the cathode, and
wherein a gate of the second transistor (M2) is connected to the cathode.

4. The device (10, 40a, 40b, 70a, 70b) of claim 2, further comprising:
a capacitor (C) connected between the anode and a gate of the second transistor (M2); and
a resistor (Ra) connected between the gate of the second transistor (M2) and the cathode,
wherein a gate of the at least one first transistor (M1) is connected to the cathode.

5. The device (10, 40a, 40b, 70a, 70b) of claim 1, wherein the at least one first transistor (M1) comprises an n-channel field effect transistor ,NFET,
wherein the second transistor (M2) comprises a p-channel field effect transistor ,PFET, and
wherein the source of the second transistor (M2) is connected to the anode.

6. The device (10, 40a, 40b, 70a, 70b) of claim 5, wherein a gate of the at least one first transistor (M1) is connected to the cathode, and
wherein a gate of the second transistor (M2) is connected to the anode.

7. The device (10, 40a, 40b, 70a, 70b) of claim 5, further comprising:
a resistor connected between the anode and a gate of the second transistor (M2); and
a capacitor (C) connected between the gate of the second transistor (M2) and the cathode,
wherein a gate of the at least one first transistor (M1) is connected to the cathode.

8. The device (10, 40a, 40b, 70a, 70b) of claim 1, wherein the at least one first transistor (M1) comprises a plurality of first transistors (M1) which are serially connected between the anode and the gate of the silicon controlled rectifier (SCR, 41a, 41b, 71a, 71b).

9. The device (10, 40a, 40b, 70a, 70b) of claim 1, wherein a channel width of the second transistor (M2) is different from a channel width of the at least one first transistor (M1).

10. The device (10, 40a, 40b, 70a, 70b) of claim 1, further comprising:
a capacitor (C) connected between the anode and a gate of the at least one first transistor (M1); and
a resistor (Rp) connected between the gate of the at least one first transistor (M1) and the cathode.

11. The device (10, 40a, 40b, 70a, 70b) of claim 1, wherein the silicon controlled rectifier (SCR, 41a, 41b, 71a, 71b) comprises:
a PNP bipolar transistor (Qp) and an NPN bipolar transistor (Qn), wherein a base of the NPN bipolar transistor (Qn) is connected to a collector of the PNP bipolar transistor (Qp), and wherein a collector of the NPN bipolar transistor (Qn) is connected to a base of the PNP bipolar transistor (Qp); and
a resistor connected between the base of the PNP bipolar transistor (Qp) and the anode.

12. The device (10, 40a, 40b, 70a, 70b) of claim 11, wherein the silicon controlled rectifier (SCR, 41a, 41b, 71a, 71b) further comprises at least one diode connected between the anode and an emitter of the PNP bipolar transistor (Qp).

13. The device (10, 40a, 40b, 70a, 70b) of claim 11, wherein the silicon controlled rectifier (SCR, 41a, 41b, 71a, 71b) further comprises at least one diode connected between an emitter of the NPN bipolar transistor (Qn) and the cathode.

14. The device (10, 40a, 40b, 70a, 70b) of claim 11, wherein an emitter of the PNP bipolar transistor corresponds to a p+ doping region,
wherein the base of the PNP bipolar transistor corresponds to an n-well connected to the p+ doping region,
wherein the collector of the PNP bipolar transistor corresponds to a p-well connected to the n-well,
wherein an emitter of the NPN bipolar transistor corresponds to an n+ doping region connected to the p-well,
wherein the base of the NPN bipolar transistor corresponds to the p-well, and
wherein the collector of the NPN bipolar transistor corresponds to the n-well.

15. The device (10, 40a, 40b, 70a, 70b) of claim 14, wherein the resistor (Ra) comprises a resistor corresponding to the n-well.

## Patentansprüche

1. Vorrichtung (10, 40a, 40b, 70a, 70b), aufweisend:
einen Silizium-gesteuerten Gleichrichter (SCR, 41a, 41b, 71a, 71b);
mindestens einen ersten Transistor (M1), der zwischen einer Anode des Silizium-gesteuerten Gleichrichters (SCR, 41a, 41b, 71a, 71b) und einem Gate des Silizium-gesteuerten Gleichrichters (SCR, 41a, 41b, 71a, 71b) geschaltet ist; und
einen zweiten Transistor (M2), wobei eine Source des zweiten Transistors (M2) mit der Anode oder einer Kathode des Silizium-gesteuerten Gleichrichters (SCR, 41a, 41b, 71a, 71b) verbunden ist, und wobei ein Drain des zweiten Transistors (M2) mit einem Body des mindestens einen ersten Transistors (M1) verbunden ist, **dadurch gekennzeichnet, dass** der Drain des zweiten Transistors nicht mit einer Source des mindestens einen ersten Transistors (M1) verbunden ist.

2. Vorrichtung (10, 40a, 40b, 70a, 70b) nach Anspruch 1, wobei der mindestens eine erste Transistor (M1) und der zweite Transistor (M2) jeweils einen n-Kanal-Feldeffekttransistor, NFET, aufweisen und
wobei die Source des zweiten Transistors (M2) mit der Kathode verbunden ist.

3. Vorrichtung (10, 40a, 40b, 70a, 70b) nach Anspruch 2, wobei ein Gate des mindestens einen ersten Transistors (M1) mit der Kathode verbunden ist und
wobei ein Gate des zweiten Transistors (M2) mit der Kathode verbunden ist.

4. Vorrichtung (10, 40a, 40b, 70a, 70b) nach Anspruch 2, ferner aufweisend:
einen Kondensator (C), der zwischen der Anode und einem Gate des zweiten Transistors (M2) geschaltet ist; und
einen Widerstand (Ra), der zwischen dem Gate des zweiten Transistors (M2) und der Kathode geschaltet ist,
wobei ein Gate des mindestens einen ersten Transistors (M1) mit der Kathode verbunden ist.

5. Vorrichtung (10, 40a, 40b, 70a, 70b) nach Anspruch 1, wobei der mindestens eine erste Transistor (M1) einen n-Kanal-Feldeffekttransistor, NFET, aufweist,
wobei der zweite Transistor (M2) einen p-Kanal-Feldeffekttransistor, PFET, aufweist und wobei die Source des zweiten Transistors (M2) mit der Anode verbunden ist.

6. Vorrichtung (10, 40a, 40b, 70a, 70b) nach Anspruch 5, wobei ein Gate des mindestens einen ersten Transistors (M1) mit der Kathode verbunden ist und
wobei ein Gate des zweiten Transistors (M2) mit der Anode verbunden ist.

7. Vorrichtung (10, 40a, 40b, 70a, 70b) nach Anspruch 5, ferner aufweisend:
einen zwischen der Anode und einem Gate des zweiten Transistors (M2) geschalteten Widerstand; und
einen zwischen dem Gate des zweiten Transistors (M2) und der Kathode geschalteten Kondensator (C),
wobei ein Gate des mindestens einen ersten Transistors (M1) mit der Kathode verbunden ist.

8. Vorrichtung (10, 40a, 40b, 70a, 70b) nach Anspruch 1, wobei der mindestens eine erste Transistor (M1) eine Vielzahl von ersten Transistoren (M1) aufweist, die in Reihe zwischen der Anode und dem Gate des Silizium-gesteuerten Gleichrichters (SCR, 41a, 41b, 71a, 71b) geschaltet sind.

9. Vorrichtung (10, 40a, 40b, 70a, 70b) nach Anspruch 1, wobei sich die Kanalbreite des zweiten Transistors (M2) von einer Kanalbreite des mindestens einen ersten Transistors (M1) unterscheidet.

10. Vorrichtung (10, 40a, 40b, 70a, 70b) nach Anspruch 1, ferner aufweisend:
einen Kondensator (C), der zwischen der Anode und einem Gate des mindestens einen ersten Transistors (M1) geschaltet ist; und
einen Widerstand (Rp), der zwischen dem Gate des mindestens einen ersten Transistors (M1) und der Kathode geschaltet ist.

11. Vorrichtung (10, 40a, 40b, 70a, 70b) nach Anspruch 1, wobei der Silizium-gesteuerte Gleichrichter (SCR, 41a, 41b, 71a, 71b) aufweist:
einen PNP-Bipolartransistor (Qp) und einen NPN-Bipolartransistor (Qn), wobei eine Basis des NPN-Bipolartransistors (Qn) mit einem Kollektor des PNP-Bipolartransistors (Qp) verbunden ist und wobei ein Kollektor des NPN-Bipolartransistors (Qn) mit einer Basis des PNP-Bipolartransistors (Qp) verbunden ist; und
einen zwischen der Basis des PNP-Bipolartransistors (Qp) und der Anode geschalteten Widerstand.

12. Vorrichtung (10, 40a, 40b, 70a, 70b) nach Anspruch 11, wobei der Silizium-gesteuerte Gleichrichter (SCR, 41a, 41b, 71a, 71b) ferner mindestens eine Diode aufweist, die zwischen der Anode und einem Emitter des PNP-Bipolartransistors (Qp) geschaltet ist.

13. Vorrichtung (10, 40a, 40b, 70a, 70b) nach Anspruch 11, wobei der Silizium-gesteuerte Gleichrichter (SCR, 41a, 41b, 71a, 71b) ferner mindestens eine Diode umfasst, die zwischen einem Emitter des NPN-Bipolartransistors (Qn) und der Kathode geschaltet ist.

14. Vorrichtung (10, 40a, 40b, 70a, 70b) nach Anspruch 11, wobei ein Emitter des PNP-Bipolartransistors einem p+-Dotierungsbereich entspricht,
wobei die Basis des PNP-Bipolartransistors einem n-Well entspricht, der mit dem p+-Dotierungsbereich verbunden ist,
wobei der Kollektor des PNP-Bipolartransistors einem mit dem n-Well verbundenen p-Well entspricht,
wobei ein Emitter des NPN-Bipolartransistors einem mit dem p-Well verbundenen n+-Dotierungsbereich entspricht,
wobei die Basis des NPN-Bipolartransistors dem p-Well entspricht und
wobei der Kollektor des NPN-Bipolartransistors dem n-Well entspricht.

15. Vorrichtung (10, 40a, 40b, 70a, 70b) nach Anspruch 14, wobei der Widerstand (Ra) einen Widerstand aufweist, der der n-Well entspricht.

## Revendications

1. Dispositif (10, 40a, 40b, 70a, 70b), comprenant :
un redresseur commandé au silicium (SCR, 41a, 41b, 71a, 71b) ;
au moins un premier transistor (M1) relié entre une anode du redresseur commandé au silicium (SCR, 41a, 41b, 71a, 71b) et une grille du redresseur commandé au silicium (SCR, 41a, 41b, 71a, 71b) ; et
un deuxième transistor (M2), dans lequel une source du deuxième transistor (M2) est reliée à l'une de l'anode et de la cathode du redresseur commandé au silicium (SCR, 41a, 41b, 71a, 71b), et dans lequel un drain du deuxième transistor (M2) est relié au corps dudit au moins un premier transistor (M1),
**caractérisé en ce que** le drain du deuxième transistor n'est pas relié à une source dudit au moins un premier transistor (M1).

2. Dispositif (10, 40a, 40b, 70a, 70b) selon la revendication 1, dans lequel ledit au moins un premier transistor (M1) et le deuxième transistor (M2) comprennent chacun un transistor à effet de champ à canal n (NFET), et
dans lequel la source du deuxième transistor (M2) est reliée à la cathode.

3. Dispositif (10, 40a, 40b, 70a, 70b) selon la revendication 2, dans lequel une grille dudit au moins un premier transistor (M1) est reliée à la cathode, et
dans lequel une grille du deuxième transistor (M2) est reliée à la cathode.

4. Dispositif (10, 40a, 40b, 70a, 70b) selon la revendication 2, comprenant en outre :
un condensateur (C) relié entre l'anode et une grille du deuxième transistor (M2) ; et
une résistance (Ra) reliée entre la grille du deuxième transistor (M2) et la cathode,
dans lequel une grille dudit au moins un premier transistor (M1) est reliée à la cathode.

5. Dispositif (10, 40a, 40b, 70a, 70b) selon la revendication 1, dans lequel ledit au moins un premier transistor (M1) comprend un transistor à effet de champ à canal n (NFET),
dans lequel le deuxième transistor (M2) comprend un transistor à effet de champ à canal p (PFET), et
dans lequel la source du deuxième transistor (M2) est reliée à l'anode.

6. Dispositif (10, 40a, 40b, 70a, 70b) selon la revendication 5, dans lequel une grille dudit au moins un premier transistor (M1) est reliée à la cathode, et
dans lequel une grille du deuxième transistor (M2) est reliée à l'anode.

7. Dispositif (10, 40a, 40b, 70a, 70b) selon la revendication 5, comprenant en outre :
une résistance reliée entre l'anode et une grille du deuxième transistor (M2) ; et
un condensateur (C) relié entre la grille du deuxième transistor (M2) et la cathode,
dans lequel une grille dudit au moins un premier transistor (M1) est reliée à la cathode.

8. Dispositif (10, 40a, 40b, 70a, 70b) selon la revendication 1, dans lequel ledit au moins un premier transistor (M1) comprend une pluralité de premiers transistors (M1) qui sont reliés en série entre l'anode et la grille du redresseur commandé au silicium (SCR, 41a, 41b, 71a, 71b).

9. Dispositif (10, 40a, 40b, 70a, 70b) selon la revendication 1, dans lequel une largeur de canal du deuxième transistor (M2) est différente de celle dudit au moins un premier transistor (M1).

10. Dispositif (10, 40a, 40b, 70a, 70b) selon la revendication 1, comprenant en outre :
un condensateur (C) relié entre l'anode et une grille dudit au moins un premier transistor (M1) ; et
une résistance (Rp) reliée entre la grille dudit au moins un premier transistor (M1) et la cathode.

11. Dispositif (10, 40a, 40b, 70a, 70b) selon la revendication 1, dans lequel le redresseur commandé au silicium (SCR, 41a, 41b, 71a, 71b) comprend :
un transistor bipolaire PNP (Qp) et un transistor bipolaire NPN (Qn), dans lequel une base du transistor bipolaire NPN (Qn) est reliée à un collecteur du transistor bipolaire PNP (Qp), et dans lequel un collecteur du transistor bipolaire NPN (Qn) est relié à une base du transistor bipolaire PNP (Qp) ; et
une résistance reliée entre la base du transistor bipolaire PNP (Qp) et l'anode.

12. Dispositif (10, 40a, 40b, 70a, 70b) selon la revendication 11, dans lequel le redresseur commandé au silicium (SCR, 41a, 41b, 71a, 71b) comprend en outre au moins une diode reliée entre l'anode et un émetteur du transistor bipolaire PNP (Qp).

13. Dispositif (10, 40a, 40b, 70a, 70b) selon la revendication 11, dans lequel le redresseur commandé au silicium (SCR, 41a, 41b, 71a, 71b) comprend en outre au moins une diode reliée entre un émetteur du transistor bipolaire NPN (Qn) et la cathode.

14. Dispositif (10, 40a, 40b, 70a, 70b) selon la revendication 11, dans lequel un émetteur du transistor bipolaire PNP correspond à une région dopée p+,
dans lequel la base du transistor bipolaire PNP correspond à un puits n relié à ladite région dopée p+,
dans lequel le collecteur du transistor bipolaire PNP correspond à un puits p relié audit puits n,
dans lequel un émetteur du transistor bipolaire NPN correspond à une région dopée n+ reliée audit puits p,
dans lequel la base du transistor bipolaire NPN correspond audit puits p, et
dans lequel le collecteur du transistor bipolaire NPN correspond audit puits n.

15. Dispositif (10, 40a, 40b, 70a, 70b) selon la revendication 14, dans lequel la résistance (Ra) comprend une résistance correspondant au puits n.
